# EUROPEAN PATENT APPLICATION

(11) **EP 4 130 826 A1**
(43) Date of publication of application: **08.02.2023**
(21) Application number: 21780430.1
(22) Date of filing: 05.02.2021
(51) Int. Cl.: G02B 6/42, H01S 5/022, H01S 5/024, H01S 5/40

(54) **SUPPORT MEMBER, WAVELENGTH SYNTHESIS MODULE, AND LIGHT EMITTING DEVICE**

(30) Priority: 31.03.2020 JP 2020062219
(71) Applicant: FURUKAWA ELECTRIC CO., LTD., Chiyoda-ku Tokyo 100-8322 (JP)
(72) Inventor: SHIBUYA, Satoshi, Tokyo 100-8322 (JP); HAYAMIZU, Naoki, Tokyo 100-8322 (JP); YOSHIZAKI, Tatsuya, Tokyo 100-8322 (JP); OKADA, Ayato, Tokyo 100-8322 (JP)
(74) Representative: SSM Sandmair
(86) International application number: PCT/JP2021/004448
(87) International publication number: WO 2021/199678

(57) **Abstract**

A supporting member supports a peeled end portion an optical fiber, which includes a core wire having a core and a cladding and includes a jacket used to enclose the core wire. The peeled end portion is formed at an end portion in the longitudinal direction representing a first direction of the optical fiber, and has the core wire in the exposed state as a result of removal of the jacket. The supporting member includes a first member, and a second member that is fixed to the first member. In between the first member and the second member, a housing portion is provided which extends along the peeled end portion and in which the peeled end portion is housed. The supporting member also includes a processed member that is housed in the housing portion and around the peeled end portion, and that causes transmission or scattering of the light leaking from the peeled end portion.

## Description

### Field

The present invention is related to a supporting member, a wavelength combining module, and a light emitting device.

### Background

Conventionally, as a configuration of the portion meant for coupling a laser light to an optical fiber; a configuration is known in which a glass capillary is disposed on the outer periphery of the optical fiber for the purpose of fixating the optical fiber, and an optical absorber is disposed on the outer periphery of the glass capillary for the purpose of fixating the glass capillary via a fixative (refer to Patent Literature 1).

### Citation List

### Patent Literature

Patent Literature 1: International Laid-open Pamphlet No. 2015/037725

### Summary

### Technical Problem

However, in the configuration disclosed in Patent Literature 1 mentioned above, accompanying the enhancement in the power of the laser light, when there is an increase in the power of the laser light propagating in the cladding mode, the laser light that propagates in the cladding mode but leaks out from the cladding may cause damage to the fixative.

In that regard, one of the objectives of the present invention is to obtain, for example, a supporting member that is to be used for an optical fiber and that has a new and more reliable configuration; a wavelength combining module; and a light emitting device.

### Solution to Problem

A supporting member according to the present invention, for example, supports a peeled end portion formed at an end portion in longitudinal direction representing first direction of an optical fiber, the optical fiber including: a core wire including a core and a cladding; and a jacket configured to enclose the core wire, the jacket being removed at the peeled end portion to expose the core wire, and includes: a first member; a second member fixed to the first member; a housing portion provided between the first member and the second member, the housing portion extending along the peeled end portion and being configured to house the peeled end portion; and a processed member housed in the housing portion and provided around the peeled end portion, the processed member being configured to cause transmission or scattering of light leaking from the peeled end portion.

In the supporting member, the first member may include a first recessed groove configured to house the peeled end portion, and the second member may be configured to cover the first recessed groove and the peeled end portion.

In the supporting member, the first recessed groove may be a V-shaped groove.

In the supporting member, the first member and the second member may support the peeled end portion in a state in which a section having a predetermined length from a first end portion in the first direction of the peeled end portion is exposed from the housing portion.

In the supporting member, the supporting member may include a fixating member configured to fixate at least either the first member or the second member to the optical fiber.

In the supporting member, the fixating member may be positioned away from a second end portion present in the first direction of at least either the first member or the second member in opposite direction of the first direction.

In the supporting member, at least either the first member or the second member may include a second recessed groove configured to house a region of the optical fiber fixed using the fixating member.

In the supporting member, at least either the first member or the second member may include a recessed portion configured to house the fixating member.

In the supporting member, the recessed portion may be positioned away from a second end portion present in the first direction of at least either the first member or the second member in opposite direction of the first direction.

In the supporting member, the fixating member may be configured to fixate one of the first member and the second member to the optical fiber, and another one of the first member and the second member may include an opening from which the fixating member is exposed.

In the supporting member, the opening may be positioned away from a third end portion present in the first direction of the other member in opposite direction of the first direction.

In the supporting member, the fixating member may be positioned, with respect to the processed member, on opposite side of a first end portion present in the first direction of the peeled end portion.

In the supporting member, the fixating member may be an inorganic adhesive agent.

The supporting member may include a cushioning member disposed facing a first end portion present in first direction of the peeled end portion, the cushioning member including an end face positioned on opposite side of the first end portion, the end face being wider than the first end portion, and the cushioning member being configured to propagate incident light from the end face to the first end portion.

The supporting member may include a reflecting surface facing the cushioning member and configured to reflect light coming from the cushioning member in a direction away from the cushioning member.

In the supporting member, at least either the first member or the second member may be made of copper or aluminum.

Moreover, a wavelength combining module according to the present invention, for example, includes: a plurality of optical fibers each including a core wire including a core and a cladding, a jacket configured to enclose the core wire, and a peeled end portion where the jacket is removed to expose the core wire at an end portion in longitudinal direction, the plurality of optical fibers including a plurality of input-type optical fibers each of which inputs light having a different wavelength, and an output-type optical fiber which outputs light; a plurality of supporting parts configured to support the peeled end portion of the plurality of optical fibers; and a light combining unit configured to combinecombine lights having different wavelengths and coming from the input-type optical fibers, and send combined light to the output-type optical fiber, wherein at least one of the plurality of supporting parts includes a first member, a second member fixed to the first member, a housing portion provided between the first member and the second member, the housing portion extending along the peeled end portion and being configured to house the peeled end portion, and a processed member housed in the housing portion and provided around the peeled end portion, the processed member being configured to cause transmission or scattering of light leaking from the peeled end portion.

In the wavelength combining module, the input-type optical fibers may include a first input-type optical fiber configured to input, in a first input direction, light having a first wavelength, and a second input-type optical fiber configured to input, in a second input direction, light having a second wavelength which is different than the first wavelength, and the light combining unit may include a filter configured to allow passage of light having the first wavelength, and reflect light having the second wavelength, a first face on which light having the first wavelength falls in the first input direction, and a second face which is substantially parallel to the first face, from which light having the first wavelength goes out, on which light having the second wavelength falls in the second input direction, and from which light having the second wavelength goes out substantially parallel to outgoing direction of light having the first wavelength, and the filter having incidence angle of light having the second wavelength with respect to the second face to be greater than 0° and equal to smaller than 20°.

In the wavelength combining module, light input from at least one of the input-type optical fibers may include a plurality of lights having different orientations of polarization plane.

In the wavelength combining module, the plurality of input-type optical fibers may be polarization maintaining optical fibers.

In the wavelength combining module, light input from at least one of the plurality of input-type optical fibers may include a plurality of lights having different wavelengths.

Moreover, a light emitting device according to the present invention, for example, includes: a plurality of light emitting elements; a light combining unit configured to combine light coming from the plurality of light emitting elements; an output-type optical fiber configured to output combined light obtained by the light combining unit, and including a core wire including a core and a cladding, a jacket configured to enclose the core wire, and a peeled end portion where the jacket is removed to expose the core wire; and a supporting part configured to support the peeled end portion, the supporting part including a first member, a second member fixed to the first member, a housing portion provided between the first member and the second member, the housing portion extending along the peeled end portion and being configured to house the peeled end portion, and a processed member housed in the housing portion and provided around the peeled end portion, the processed member being configured to cause transmission or scattering of light leaking from the peeled end portion.

The light emitting device may include a housing including a cooling passage configured to enable passage of a cooling medium, the housing being configured to enable cooling of the plurality of light emitting elements and the supporting part when a cooling medium is passed through the cooling passage.

In the light emitting device, the plurality of light emitting elements may be configured to emit lights having different wavelengths, and order of cooling of the light emitting elements due to cooling medium passing through the cooling passage may be according to descending order of wavelengths of lights emitted from the light emitting elements.

### Advantageous Effects of Invention

According to the present invention, for example, it becomes possible to obtain a supporting member having a new and more reliable configuration; a wavelength combining module; and a light emitting device.

### Brief Description of Drawings

FIG. 1 is an exemplary and schematic perspective view of a supporting member according to a first embodiment.
FIG. 2 is an II-II cross-sectional view of FIG. 1.
FIG. 3 is an exemplary and schematic perspective view of the supporting member in the state in which a holder has been removed.
FIG. 4 is an exemplary and schematic perspective view of a supporting member according to a first modification example.
FIG. 5 is an exemplary and schematic planar view of a wavelength combining module according to a second embodiment.
FIG. 6 is a schematic explanatory diagram for explaining the transmission and the reflection of light in a filter installed in the wavelength combining module according to the second embodiment.
FIG. 7 is an exemplary and schematic planar view of a wavelength combining module according to a second modification example.
FIG. 8 is an exemplary explanatory diagram illustrating an input light that is output from the wavelength combining module according to the second modification example and that is input to an end face of an optical fiber, and illustrating a reflected light from a machined surface of a machining target when the machining target is irradiated with a laser light.
FIG. 9 is an exemplary and schematic planar view of a wavelength combining module according to a third modification example.
FIG. 10 is an exemplary and schematic planar view of a wavelength combining module according to a fourth modification example.
FIG. 11 is an exemplary and schematic planar view of a light emitting device according to a third embodiment.
FIG. 12 is an exemplary and schematic planar view of a light emitting device according to a fifth modification example.
FIG. 13 is a cross-sectional view, at an equivalent position to the position illustrated in FIG. 2, of a supporting member according to a sixth modification example.
FIG. 14 is an exemplary and schematic planar view of a base of the supporting member according to the sixth modification example.
FIG. 15 is an exemplary and schematic planar view of a base of a supporting member according to a seventh modification example.
FIG. 16 is an exemplary and schematic planar view of a base of a supporting member according to an eighth modification example.
FIG. 17 is an exemplary and schematic perspective view of a supporting member according to a fourth embodiment.
FIG. 18 is an exemplary and schematic perspective view of a base of the supporting member according to the fourth embodiment.
FIG. 19 is an XIX-XIX cross-sectional view of FIG. 17.
FIG. 20 is an exemplary and schematic perspective view of a supporting member according to a ninth modification example.
FIG. 21 is an exemplary and schematic perspective view of a supporting member according to a 10-th modification example.
FIG. 22 is an exemplary and schematic perspective view of a supporting member according to a fifth embodiment.
FIG. 23 is an exemplary and schematic perspective view of a base of the supporting member according to the fifth embodiment.
FIG. 24 is an XXIV-XXIV cross-sectional view of FIG. 22.
FIG. 25 is a cross-sectional view, at an equivalent position to the position illustrated in FIG. 19, of a supporting member according to a sixth embodiment.
FIG. 26 is an exemplary and schematic perspective view of a cover of the supporting member according to the sixth embodiment.
FIG. 27 is an exemplary and schematic perspective view of a cover of a supporting member according to an 11-modification example.

### Description of Embodiments

Exemplary embodiments and modification examples of the present invention are described below. The configurations according to the embodiments and the modification examples, as well as the actions and the results (effects) attributed to the configurations are only exemplary. The present invention can also be implemented using a configuration different than the configurations according to the embodiments and the modification examples described below. Moreover, according to the present invention, it is possible to achieve at least one of a variety of effects (including secondary effects) attributed to the configurations.

The embodiments and the modification examples described below include identical configurations. Hence, due to the identical configurations according to the embodiments and the modification examples, identical actions and identical effects are obtained. Moreover, in the following explanation, the same configurations have the same reference numerals assigned thereto, and their explanation is not given repeatedly.

In the present written description, the ordinal numbers are assigned for distinguishing among the components and the regions, and they do not indicate the priority order or the sequence.

In the drawings, the direction X is indicated by an arrow X, the direction Y is indicated by an arrow Y, and the direction Z is indicated by an arrow Z. The directions X, Y, and Z intersect with each other as well as are orthogonal to each other. The X direction can also be called the extending direction of a peeled end portion 20a of an optical fiber 20A.

### [First embodiment]

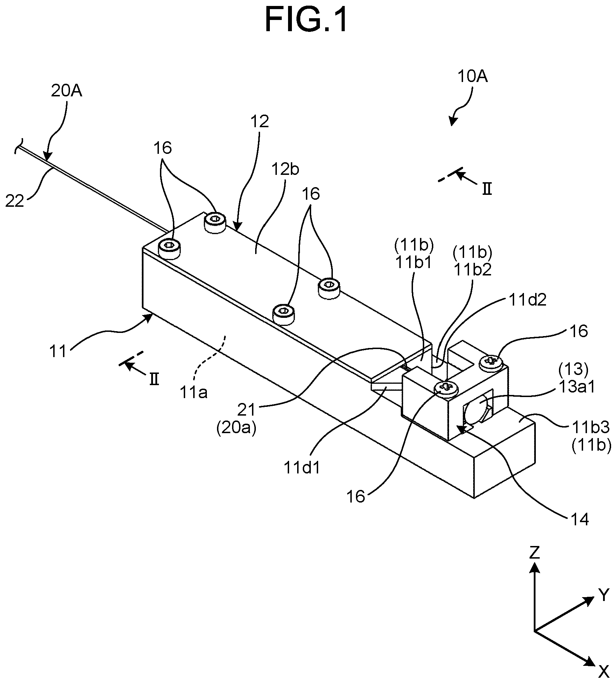

FIG. 1 is a perspective view of a supporting member 10A according to a first embodiment. The supporting member 10A is used in a variety of optical devices, particularly for supporting an end portion of the optical fiber 20A representing an output-type optical fiber that outputs a laser light. The supporting member 10A can also be called an end-portion support structure or a supporting part.

As illustrated in FIG. 1, the supporting member 10A includes a base 11, a cover 12, an end cap 13, and a holder 14.

The base 11 has a cuboid shape extending in the X direction, and supports the optical fiber 20A that too extends in the X direction.

The base 11 has a face 11a positioned at the end portion on the opposite side of the Z direction, and has a face 11b positioned at the end portion in the Z direction.

The face 11a is oriented in the opposite direction of the Z direction, and intersects with as well as is orthogonal to the Z direction. Herein, the face 11a is an oblong plane.

The face 11b is oriented in the Z direction, and intersects with as well as is orthogonal to the Z direction. The face 11b includes three faces 11b1, 11b2, 11b3 that are shifted from each other in the Z direction. Each of the three faces 11b1, 11b2, 11b3 is oriented in the Z direction, and intersects with as well as is orthogonal to the Z direction. Moreover, each of the three faces 11b1, 11b2, 11b3 represents a plane. The face 11b2 is shifted from the face 11b1 in the opposite direction of the Z direction; and the face 11b3 is shifted from the face 11b2 in the opposite direction of the Z direction. Herein, the faces 11b1, 11b2, and 11b3 constitute a level difference. Herein, the faces 11a, 11b1, 11b2, and 11b3 run parallel to each other.

The cover 12 intersects with as well as is orthogonal to the Z direction. The cover 12 has an oblong shape extending in the X direction.

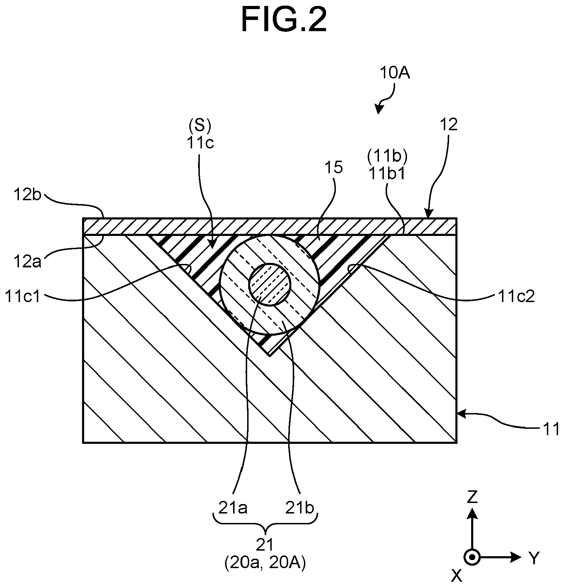

FIG. 2 is an II-II cross-sectional view of FIG. 1. As illustrated in FIG. 2, the cover 12 has a face 12a positioned at the end portion on the opposite side of the Z direction, and has a face 12b positioned at the end portion in the Z direction. The cover 12 covers the face 11b1. The face 12b faces the face 11b1, and is in contact with the face 11b1. On the face 11b1 of the base 11, a recessed groove 11c is formed that is recessed in the opposite direction of the Z direction and that extends in the X direction. In the cross-sectional surface intersecting with the X direction, the recessed groove 11c is, what is called, a V-shaped groove constituting a V-shaped cross-sectional surface. The recessed groove 11c is formed in between two faces 11c1 and 11c2. The face 11c1 goes on extending in the opposite direction of the Z direction as the distance in the Y direction increases, as well as extends in the X direction. The face 11c2 goes on extending in the Z direction as the distance in the Y direction increases, as well as extends in the X direction.

A space S that is enclosed by the faces 11c1 and 11c2 of the recessed groove 11c and the face 12a of the cover 12 extends in the X direction. In the space S, the optical fiber 20A is housed that extends in the X direction. The space S represents an example of a housing portion.

The optical fiber 20A includes a core wire 21 having a core 21a and a cladding 21b, and includes a jacket 22 for enclosing the core wire 21. The core wire 21 can be made of, for example, a silica based glass material. The jacket 22 can be made of, for example, a synthetic resin.

Within the housing section in the space S, the jacket 22 of the optical fiber 20A is removed, and the core wire 21 is exposed as a result. That is, the peeled end portion 20a, in which the jacket 22 is removed from the end portion of the optical fiber 20A and the core wire 21 is exposed, is housed in the space S. The cover 12 covers the recessed groove 11c as well as covers the peeled end portion 20a. The supporting member 10A supports the peeled end portion 20a that is housed in the space S. Herein, the base 11 represents an example of a first member, and the cover 12 represents an example of a second member.

The faces 11c1, 11c2, and 12a hold down the mispositioning of the peeled end portion 20a in the directions orthogonal to the X direction. Thus, the faces 11c1, 11c2, and 12b can also be called positioning portions or mispositioning prevention portions.

In the space S, a processed member 15 is housed in the portion excluding the optical fiber 20A. That is, the supporting member 10A includes the processed member 15. The processed member 15 is present around the peeled end portion 20a in abutting contact with the peeled end portion 20a. The processed member 15 causes transmission or scattering of the light that has leaked from the cladding 21b of the peeled end portion 20a. As a result, it becomes possible to hold down the propagation of the light from the cladding 21b to the jacket 22.

The processed member 15 can be made of, for example, an inorganic adhesive having the property of causing transmission or scattering of light. The inorganic adhesive is, for example, a silicon adhesive or an alumina adhesive. In that case, the inorganic adhesive is coated in the unhardened form and is then hardened, thereby resulting in the formation of a ceramic film. An inorganic adhesive can cause transmission or scattering of light. Meanwhile, if an organic solvent is used in the inorganic adhesive, the organic solvent vaporizes during hardening. Since an inorganic adhesive has high heat resistance, it is suitable for use as the processed member 15.

Alternatively, the processed member 15 can be made from a resin material having the property of causing transmission or scattering of light. A resin material is, for example, a silicone resin, epoxy resin, or urethane acrylate resin. The resin material can also include, for example, boron nitride, talc, or aluminum nitride as the filler. In that case, the light gets scattered due to the filler. Moreover, it is desirable that the refractive index of the filler is higher than the refractive index of the cladding 21b. Meanwhile, the resin material or the filler is not limited to the examples mentioned above.

The base 11 as well as the cover 12 can be made from, for example, a material such as copper or aluminum having high heat conductivity.

The cover 12 is fixed to the base 11 using, for example, fixtures 16 such as a screw. In the state in which the peeled end portion 20a of the optical fiber 20A and the processed member 15 are housed in the space S, the base 11 and the cover 12 are integrated together. As a result, the configuration in which the peeled end portion 20a and the processed member 15 are housed in the space S can be implemented using a relatively simple manner. Meanwhile, the base 11 and the cover 12 can be integrated according to a coupling method that is different than the coupling performed using the fixtures 16.

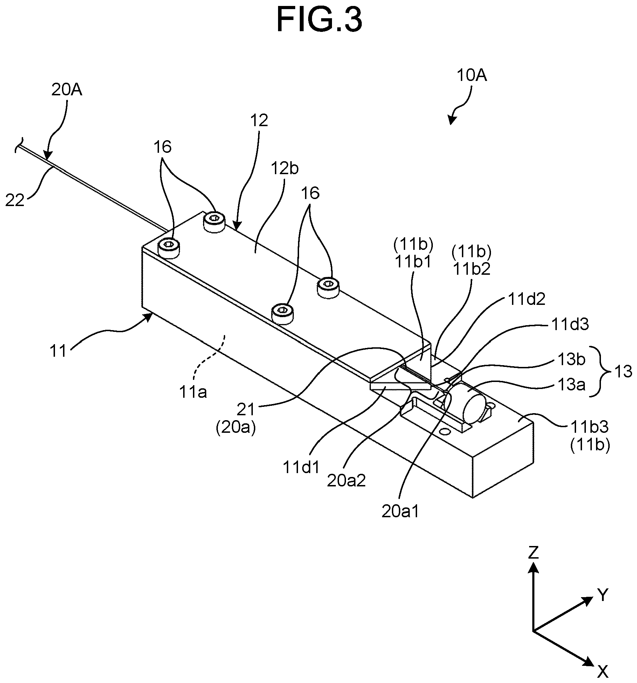

FIG. 3 is a perspective view of the supporting member 10A in the state in which the holder 14 has been removed. As illustrated in FIG. 3, a leading end 20a1 in the X direction of the peeled end portion 20a of the optical fiber 20A as well as a section 20a2 that is adjoining the leading end 20a1 and that extends for a predetermined length from the leading end 20a1 is exposed to the outside of the space S. That is, in the exposed state of the section 20a2, the supporting member 10A is supporting the peeled end portion 20a. If the optical fiber 20A is an output-type optical fiber of an optical module such as a wavelength combining module, that is, if the light is input onto the leading end 20a1 of the optical fiber 20A; then there are times when, in the vicinity of the leading end 20a1, the power of the input light becomes relatively stronger. In that case, in the vicinity of the leading end 20a1, if the surrounding of the peeled end portion 20a is covered by the base 11, the cover 12, and the processed member 15; then there is a risk of an excessive rise in the temperature of the covering portion. In that regard, in the first embodiment, the leading end 20a1 of the peeled end portion 20a as well as the surrounding of the section 20a2 adjoining the leading end 20a1 is not covered and is kept exposed. As a result, it becomes possible to avoid a situation in which an excessive rise in temperature causes damage to the configuration enclosing the peeled end portion 20a. The leading end 20a1 represents an example of an end portion in the longitudinal direction. Meanwhile, it is desirable that the length of the exposed section 20a2 is equal to or greater than 5 mm and equal to or smaller than 25 mm. If the section 20a2 is too long, then the refractive-index difference between the cladding 21b and the atmosphere sometimes results in the confinement of the propagating light, which propagates in the cladding mode, inside the cladding 21b. The X direction represents an example of a first direction, and the leading end 20a1 of the peeled end portion 20a represents an example of a first end portion.

The end cap 13 faces the leading end 20a1 of the peeled end portion 20a in the X direction. The end cap 13 includes a columnar portion 13a and a protruding portion 13b. The columnar portion 13a is columnar in shape, has a sufficiently larger diameter than the diameter of the peeled end portion 20a, and extends in the X direction. An end face 13a1 in the X direction of the columnar portion 13a is wider than the leading end 20a1. The protruding portion 13b protrudes in the opposite direction of the X direction and moves closer from the columnar portion 13a to the leading end 20a1. The protruding portion 13b is, for example, fusion-spliced with the peeled end portion 20a.

The end cap 13 can be made from a material having a comparable refractive index to the refractive index of the core 21a of the optical fiber 20A. As an example, the end cap 13 can be made from, for example, a silica based glass material same as the core 21a of the optical fiber 20A.

In a configuration in which the end cap 13 is not used, when the laser light that is collected by a collecting lens (not illustrated) travels toward the leading end 20a1 of the peeled end portion 20a; at the interface of the leading end 20a1, the beam diameter becomes smaller and the power density becomes excessively large. That results in an excessive rise in the temperature at the leading end 20a1 of the peeled end portion 20a, which in turn may result in damaging the leading end 20a1. In that regard, in the first embodiment, the laser light reaches the end face 13a1 of the end cap 13 in the state of having a larger beam diameter and a lower power density. That enables holding down an excessive rise in temperature at the end face 13a1 of the end cap 13, and in turn enables holding down any damage to the leading end 20a1. The end cap 13 represents an example of a cushioning member.

Moreover, in the end cap 13, AR (anti reflection) coating is applied at the end face 13a1 that is present on the opposite side of the protruding portion 13b. As a result, it becomes possible to suppress the reflection of light from the end face 13a1.

The end cap 13 is enclosed by the base 11, and by the holder 14 that is positioned on the opposite side of the base 11 with respect to the end cap 13. The holder 14 is fixed to the base 11 using the fixtures 16 such as a screw. The end cap 13 can be retained using the base 11 and the holder 14, or can be retained using only the base 11.

At a distant position on the opposite side of the end cap 13 in the X direction, a reflection member 11d is disposed. The reflection member 11d faces the end cap 13. In the base 11, the reflection member 11d is formed on a stepped face extending in the Z direction in between the faces 11b1 and 11b2. For example, the reflection member 11d can be formed by processing some part of the base 11 and performing plating thereon. Alternatively, the reflection member 11d can be separately manufactured and then attached to the base 11. The reflection member 11d has two reflecting surfaces 11d1 and 11d2 extending in the Z direction. The two reflecting surfaces 11d1 and 11d2 intersect with each other at a leading end 11d3 positioned in the vicinity of the peeled end portion 20a. With an increase in the distance from the leading end 11d3 toward the opposite direction of the X direction, the reflecting surface 11d1 extends toward the opposite direction of the Y direction. On the other hand, with an increase in the distance from the leading end 11d3 toward the opposite direction of the X direction, the reflecting surface 11d2 extends toward the Y direction. With such a configuration, the light that arrives from the end cap 13 but does not get coupled with the core 21a of the optical fiber 20A gets reflected from the reflection member 11d in a direction away from the end cap 13, that is, in the Y direction or in the opposite direction of the Y direction as an example in the first embodiment. As a result, it becomes possible to avoid a situation in which the light that leaked from the end cap 13 gets reflected from the base 11 and returns to the end cap 13, thereby resulting in the rise in temperature of the end cap 13. Meanwhile, the reflection member 11d is not limited to have the configuration illustrated in FIG. 3. Moreover, instead of using the reflection member 11d, it is also possible to use a scattering member having a scattering surface for causing scattering of light.

As explained above, in the first embodiment, in between the base 11 (a first material) and the cover 12 (a second material), the space S is formed that extends along the peeled end portion 20a and that is used for housing the peeled end portion 20a. The processed member 15 is also housed in the space S and is present around the peeled end portion 20a, and causes transmission or scattering of the light that has leaked from the peeled end portion 20a.

With such a configuration, the light that has leaked from the peeled end portion 20a gets transmitted or scattered due to the processed member 15 which is disposed around the peeled end portion 20a. As a result, a configuration that enables holding down a rise in temperature of the peeled end portion 20a can be implemented in a relatively simpler manner.

Moreover, in the first embodiment, for example, in the base 11, the recessed groove 11c is formed in which the peeled end portion 20a is housed; and the cover 12 covers the recessed groove 11c and the peeled end portion 20a.

Furthermore, in the first embodiment, the recessed groove 11c is, for example, a V-shaped groove.

With such a configuration, for example, a configuration that enables holding down the mispositioning of the peeled end portion 20a with respect to the supporting member 10A and that enables positioning of the peeled end portion 20a at a predetermined position in the supporting member 10A can be implemented in a relatively simpler manner.

Moreover, in the first embodiment, for example, in the state in which the section 20a2 having a predetermined length from the leading end 20a1 (the end portion in the longitudinal direction) is exposed from the space S to the outside of the supporting member 10A, the base 11 and the cover 12 support the peeled end portion 20a.

With such a configuration, for example, it becomes possible to reduce the impact of the temperature rise in the vicinity of the leading end 20a1 of the peeled end portion 20a on the supporting member 10A.

Moreover, in the first embodiment, for example, the end cap 13 faces the leading end 20a1 of the peeled end portion 20a; has the end face 13a1 that is positioned on the opposite side of the leading end 20a1 and that is wider than the leading end 20a1; and propagates the light, which falls on the end face 13a1, to the leading end 20a1.

With such a configuration, for example, as compared to the case in which the end cap 13 is not used and the light falls directly on the leading end 20a1, it becomes possible to increase the beam diameter of the light and reduce the power density of the light. That enables holding down the rise in temperature at the interface (the end face 13a1).

Moreover, in the first embodiment, for example, at least either the base 11 or the cover 12 can be made from a material such as copper or aluminum having high heat conductivity.

With such a configuration, for example, the heat generated in the peeled end portion 20a can be released via the base 11 or the cover 12, thereby enabling holding down an excessive rise in the temperature of the peeled end portion 20a.

### [First modification example]

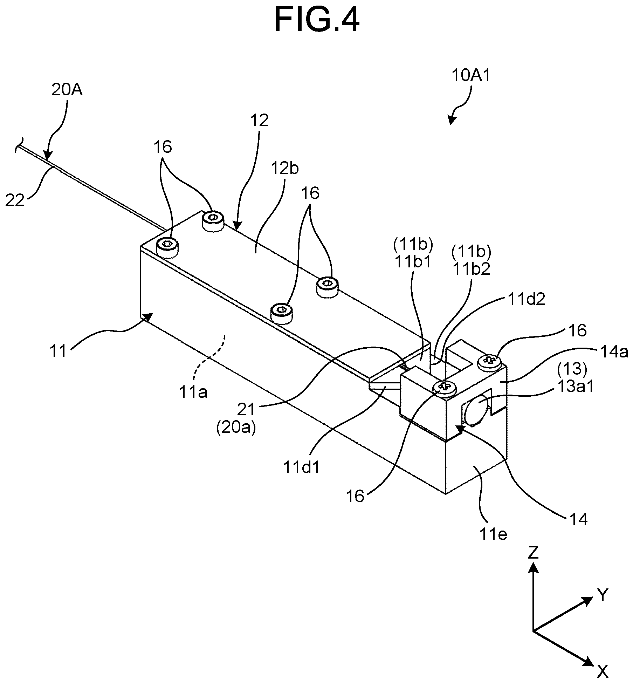

FIG. 4 is a perspective view of a supporting member 10A1 according to a first modification example representing a modification example of the first embodiment. As illustrated in FIG. 4, the supporting member 10A1 is shorter in length than the supporting member 10A according to the first embodiment; and an end face 11e of the base 11, an end face 14a of the holder 14, and the end face 13a1 of the end cap 13 all intersect with the X direction, are orthogonal to the X direction, and are arranged in a flush manner.

With such a configuration too, it becomes possible to achieve identical effects to the first embodiment. Moreover, according to the first modification example, it becomes possible to hold down the occurrence of a situation in which essentially unnecessary light gets reflected from the face 11b3 and falls on the end face 13a1.

### [Second embodiment]

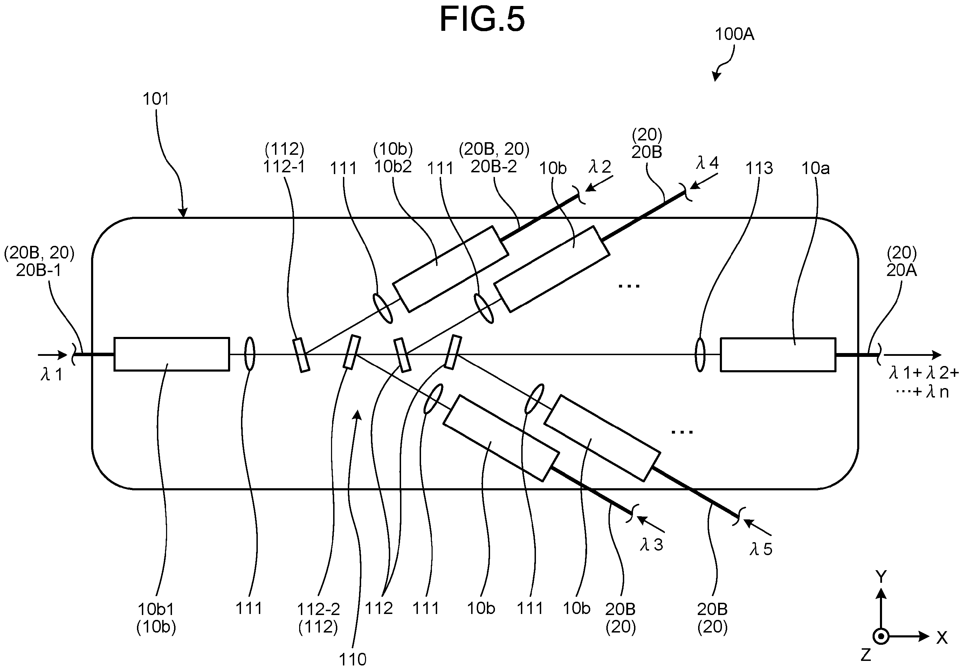

FIG. 5 is a planar view of a wavelength combining module 100A according to a second embodiment. The wavelength combining module 100A includes a housing 101, and a plurality of optical fibers 20 fixed to the housing 101. Each optical fiber 20 is connected to the housing 101 via supporting parts 10a and 10b that support the concerned peeled end portion 20a (see FIGS. 1 to 4, not illustrated in FIG. 5).

The housing 101 has, for example, a case (not illustrated) and a lid (not illustrated), and is sealed. The housing 101 is made from a material such as copper or aluminum having high heat conductivity.

The wavelength combining module 100A includes, as the optical fibers 20, optical fibers 20B that input light to the wavelength combining module 100A, and optical fibers 20A that output light from the wavelength combining module 100A. The optical fiber 20B represents an example of an input-type optical fiber, and the optical fiber 20A represents an example of an output-type optical fiber. The optical fibers 20A and 20B are, for example, multimode optical fibers. Alternatively, the optical fibers 20A and 20B can be single-mode optical fibers. In the case of a multimode optical fiber, the core diameter is, for example, in the range of 100 [µm] to 110 [µm]; the cladding diameter is, for example, in the range of 125 [µm] to 500 [µm]; and the numerical aperture is, for example, in the range of 0.15 to 0.22.

The supporting part 10a that supports the optical fiber 20A has an identical configuration to the supporting member 10A according to the first embodiment. Some portion of the supporting part 10a (for example, the base 11) can be configured in the housing 101 as a part of the housing 101. Alternatively, the supporting member 10A according to the first embodiment can be attached to the housing 101.

The supporting part 10b that supports the optical fiber 20B can have an identical configuration to the supporting member 10A, or can have a simpler configuration without including the reflection member 11d.

Each optical fiber 20B inputs a light having a different wavelength. The lights input from a plurality of optical fibers 20B are combined by a wavelength combining unit 110. The wavelength combining unit 110 includes collimation lenses 111, filters 112, and a collecting lens 113. The filters 112 can be made from, for example, a dielectric multilayer. The collimation lenses 111 convert the lights coming from the optical fibers 20B into parallel lights. The collecting lens 113 collects the input lights toward the end portion of the optical fiber 20A, so that optical coupling occurs with the optical fiber 20A. Meanwhile, the collimation lenses 111 and the collecting lens 113 can have an antireflection coating applied thereon. Herein, the wavelength combining unit 110 can also be called a light combining unit.

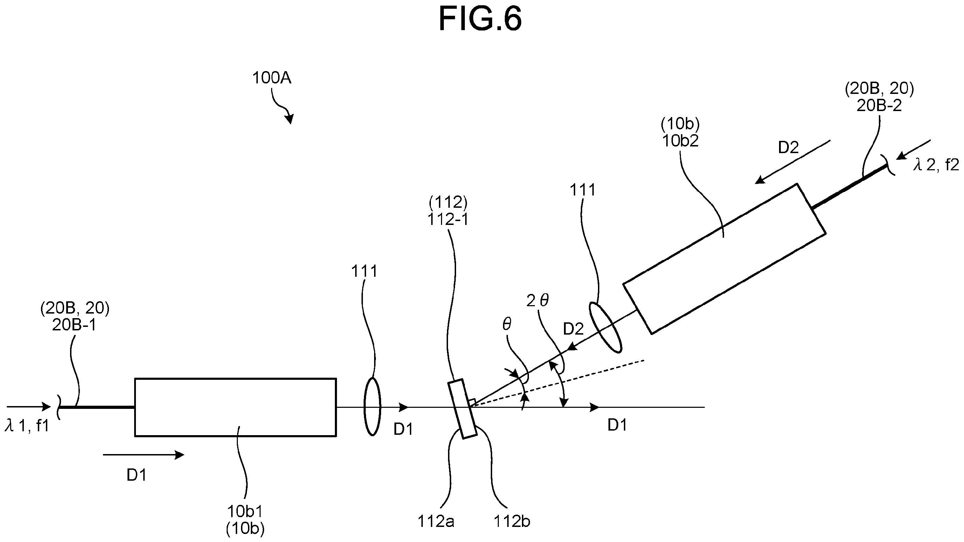

FIG. 6 is an explanatory diagram for explaining the transmission and the reflection of light in the filter 112. As illustrated in FIG. 6, the filter 112 lets the light coming from an optical fiber 20B1 (hereinafter, called a first light) pass therethrough, and reflects the light coming from another optical fiber 20B2 (hereinafter, called a second light).

In the configuration illustrated in FIG. 6, if a wavelength λ1 of the light coming from the optical fiber 20B1 is longer than a wavelength λ2 of the light coming from the optical fiber 20B2, that is, if a frequency f1 of the light coming from the optical fiber 20B1 is lower than a frequency f2 of the light coming from the optical fiber 20B2; then the filter 112 is a lowpass filter.

On the other hand, in the configuration illustrated in FIG. 6, if the wavelength λ1 of the light coming from the optical fiber 20B1 is shorter than the wavelength λ2 of the light coming from the optical fiber 20B2, that is, if the frequency f1 of the light coming from the optical fiber 20B1 is higher than the frequency f2 of the light coming from the optical fiber 20B2, then the filter 112 is a highpass filter.

The filter 112 has a first face 112a and a second face 112b. The first face 112a and the second face 112b are parallel to each other.

The first face 112a represents the incident surface for the first light, and the second face 112b represents the outgoing surface for the first light and also represents the reflection surface for the second light.

The first light travels in a direction D1 and falls on the first face 112a, and then goes out from the second face 112b and travels in the direction D1. The second light travels in a direction D2 to reach the second face 112b, and gets reflected from the second face 112b and travels in the direction D1. That is, the filter 112 is set in such a way that, if the incidence angle (=the output angle) of the second light has the absolute value of θ, then the angle difference between the direction D1 and the opposite direction of the direction D2 has the absolute value of 2θ. In such a configuration, the constituent elements are arranged in such a way that the outgoing point of the first light on a second face 111b and the reflection point of the second light on the second face 111b are substantially identical in the line of sight illustrated in FIGS. 5 and 6. As a result, the first light and the second light can be combined. Herein, the direction D1 represents an example of a first input direction, and the direction D2 represents an example of a second input direction.

Meanwhile, in the second embodiment, the direction D1 also represents the longitudinal direction of the optical fiber 20B1 and a supporting part 10b1 (10b), and the direction D2 also represents the longitudinal direction of the optical fiber 20B2 and a supporting part 10b2 (10b).

In the second embodiment, the incidence angle θ for the second light on the second face 112b is set to be equal to or smaller than 20°. The reason for that is explained below. Meanwhile, in the present written description, a filter that lets through the light having a longer wavelength than the boundary zone is called a highpass filter, and a filter that lets through the light having a shorter wavelength than the boundary zone passes is called a lowpass filter.

As far as the characteristics of such types of filters are concerned, in a filter designed for a particular polarized wave, when some other polarized wave gets mixed; an increase in the incidence angle θ leads to an increase in the wavelength bandwidth between a wavelength λmin, at which the reflectance is 100% and the transmittivity is 0%, and a wavelength λmax, at which the reflectance is 0% and the transmittivity is 100%, (hereinafter, the wavelength bandwidth is treated as the boundary zone), and leads to a decline in the cutoff characteristics of the filter. Particularly, in the case of polarization beam combining of the P waves and the S waves, the cutoff characteristics are most prone to a decline.

When polarization beam combining of the P waves and the S waves is performed and also when the boundary zone is large due to a decline in the cutoff characteristics of the filter, it becomes necessary to set a large difference between the wavelengths of the first light and the second light. That makes it inevitable to increase the wavelength interval (frequency interval) of a plurality of combining target lights having different wavelengths. It leads to the loss of ability to combine a greater number of lights having different wavelengths. In that regard, in the second embodiment, by setting the incidence angle to be equal to or smaller than 20°, the difference between the wavelengths of the first light and the second light can be set to be smaller, and the wavelength interval (frequency interval) of a plurality of combining target lights having different wavelengths can be set to be smaller. Hence, it becomes possible to combine a greater number of lights having different wavelengths. After a keen examination done by the inventors, it was evident that the incidence angle θ is desirably greater than 0° and equal to or smaller than 20° and is more desirably greater than 0° and equal to or smaller than 15°.

In the configuration illustrated in FIG. 5, a combined light formed as a result of combining the light having the wavelength λ1 and coming from the optical fiber 20B1 and the light having the wavelength λ2 and coming from the optical fiber 20B2 is output from the filter 112-1; and a combined light formed as a result of combining the light having the wavelength λ1, the light having the wavelength λ2, and the light having a wavelength λ3 and coming from an optical fiber 20B3 is output from a filter 112-2. Thus, in each filter 112, a plurality of lights having different wavelengths is sequentially combined. Then, the combined light formed as a result of combining a plurality of lights having different wavelengths (λ1, λ2, ..., λn; where n is equal to the number of optical fibers 20B) and coming from a plurality of optical fibers 20B is input to the optical fiber 20A via the collecting lens 113.

In the configuration illustrated in FIG. 5, when a plurality of filters 112 is highpass filters, every time the lights coming out from the optical fibers 20B pass through the filters 112, the lights having the shortest wavelength, that is, the lights having the highest frequency get sequentially combined. In that case, regarding the wavelengths λ1, λ2, ..., λn; the relationship λ1>λ2>...>λn holds true.

In the configuration illustrated in FIG. 5, when a plurality of filters 112 is lowpass filters, every time the lights coming out from the optical fibers 20B pass through the filters 112, the lights having the longest wavelength, that is, the light having the lowest frequency get sequentially combined. In that case, regarding the wavelengths λ1, λ2, ..., λn; the relationship λ1<λ2<...<λn holds true.

As explained above, in the wavelength combining module 100A according to the second embodiment, the supporting part 10a for the peeled end portion 20a of the optical fiber 20A (the output-type optical fiber) has the same configuration as the supporting member 10A according to the first embodiment.

With such a configuration, for example, it becomes possible to achieve identical effects to the first embodiment.

Moreover, in the second embodiment, in the filter 112 that lets through the first light having the wavelength λ1 (a first wavelength) and that reflects the second light having the wavelength λ2 (a second wavelength), the incidence angle θ of the second light with respect to the second face 112b is greater than 0° and equal to or smaller than 20°.

With such a configuration, for example, in the case in which a plurality of lights having different wavelengths is combined and when the plurality of lights include lights having different orientations of the polarization plane, the wavelength (frequency) interval of a plurality of lights having different wavelengths can be further reduced, and a greater number of lights having different wavelengths (frequencies) can be combined. Moreover, since the lights having different orientations of the polarization plane can be present among the combining target lights, as compared to the case in which only the lights having the same orientation of the polarization plane are present, the optical power at each wavelength can be increased.

### [Second modification example]

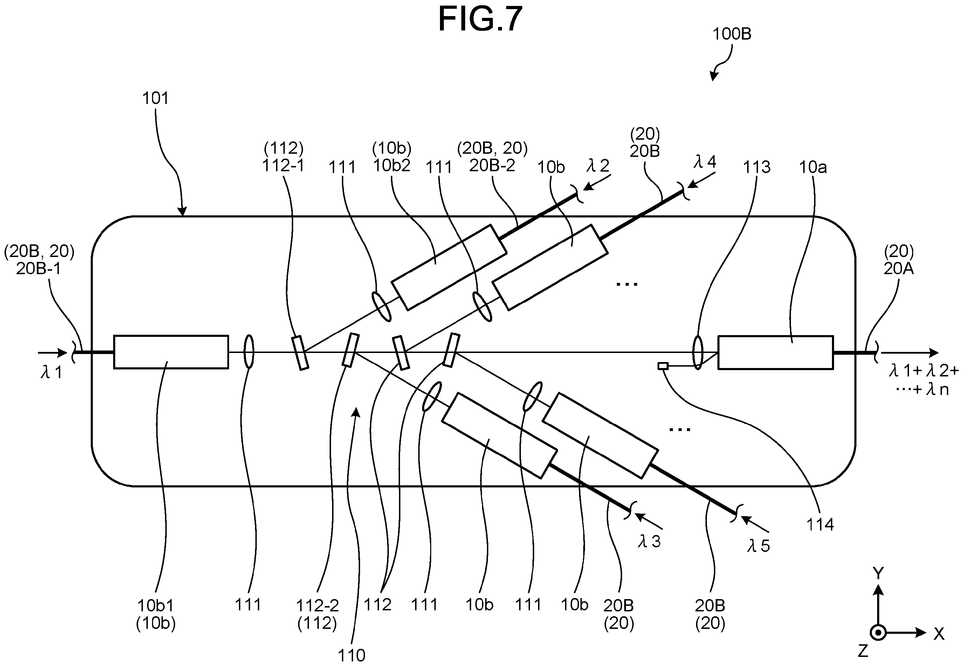

FIG. 7 is a planar view of a wavelength combining module 100B according to a second modification example representing a modification example of the second embodiment.

As illustrated in FIG. 7, the wavelength combining module 100B includes a sensor 114 that is positioned on the opposite side of the supporting part 10a with respect to the collecting lens 113 facing the supporting part 10a and that detects the reflected light coming from the supporting part 10a. The sensor 114 is, for example, a photodiode.

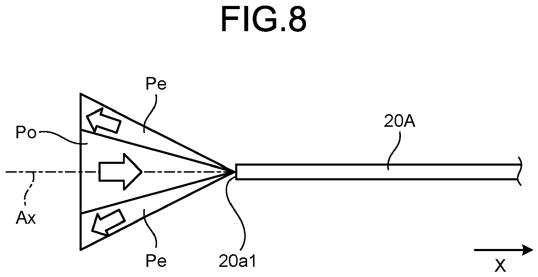

Herein, the explanation is given about an example in which the wavelength combining module 100B is used in laser machining performed with respect to a machining target. FIG. 8 is an exemplary explanatory diagram illustrating the input light that is input to the leading end 20a1 of the optical fiber 20A (i.e., the output light of the wavelength combining module 100B; hereinafter, referred to as the input light), and illustrating the reflected light obtained when the input light travels to and returns from the optical fiber 20A via a machined surface of the machining target (not illustrated) (hereinafter, simply referred to as the reflected light from the machined surface). In FIG. 8, Po represents the light path of the input light, and Pe represents the light paths of the reflected light. As illustrated in FIG. 8, the input light usually does not use the entire region of the numerical aperture (NA) of the optical fiber 20A. As an example, if the numerical aperture of the optical fiber 20A is equal to 0.22, the numerical aperture of the input light is approximately equal to 0.18. That is because, if the numerical aperture corresponding to the angle of the input light becomes equal to or greater than 0.18, it results in an increase in the coupling loss. In contrast, the reflected light from the machined surface has a spread angle equivalent to the numerical aperture of the optical fiber 20A; and, as compared to the light path Po of the output light, also passes through the outside regions separated from an optical axis Ax.

Thus, in the second modification example, the sensor 114 is disposed at a position to which the reflected light from the machined surface can reach via the collecting lens 113 after travelling along the light paths Pe, which are in the outside regions as compared the light path Po of the output light.

That gives the advantage of being able to detect the reflected light without affecting the propagation of light.

### [Third modification example]

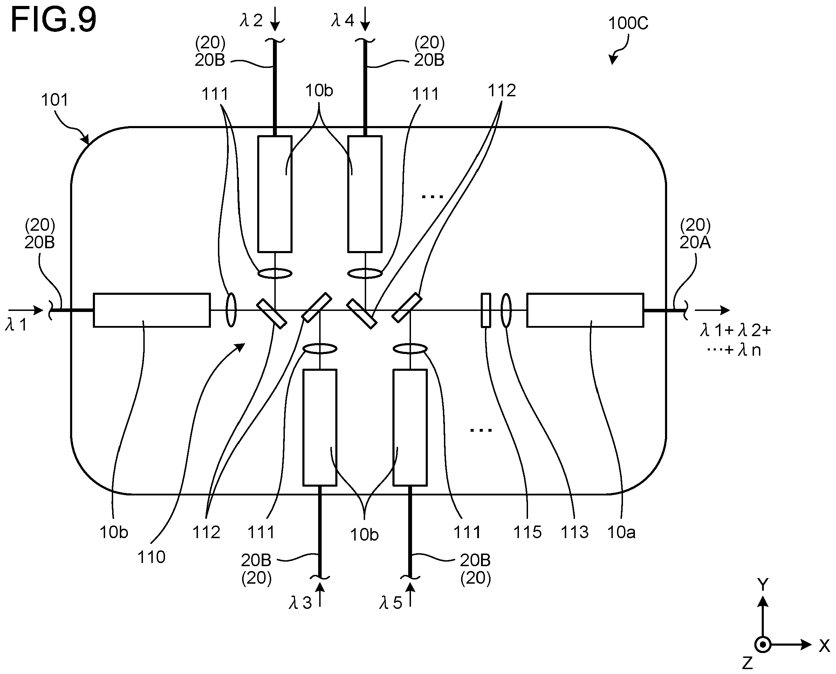

FIG. 9 is a planar view of a wavelength combining module 100C according to a third modification example representing a modification example of the second embodiment.

In the wavelength combining module 100C illustrated in FIG. 9, all of the optical fibers 20A and 20B are polarization maintaining optical fibers, and linear polarized lights having the same orientation of the polarization plane are input from all optical fibers 20B. The orientation of the polarization plane is set in such a way that the light input to the first face 112a and the light input to the second face 112b of each filter 112 serve as the S waves with respect to the first face 112a and the second face 112b. Accordingly, since a decline in the cutoff characteristics attributed to the orientation of polarization plane does not occur in the filters 112, the incidence angle of the second light can be set to 45°. As a result, the optical fibers 20B can be arranged with the directions D1 and D2 being orthogonal to each other. Meanwhile, the optical fibers 20A and 20B either can be multimode optical fibers or can be single-mode optical fibers.

Moreover, with respect to the collecting lens 113, on the opposite side of the supporting part 10a, a reflected-light cutoff filter 115 is disposed. The reflected-light cutoff filter 115 prevents the return of the light from the optical fiber 20A.

If FIG. 9 is compared with FIG. 6 or FIG. 7, it becomes clear that the arrangement of the optical fibers 20B and the supporting part 10a according to the third modification example enables making the wavelength combining module 100C more compact in the X direction illustrated in FIG. 9.

### [Fourth modification example]

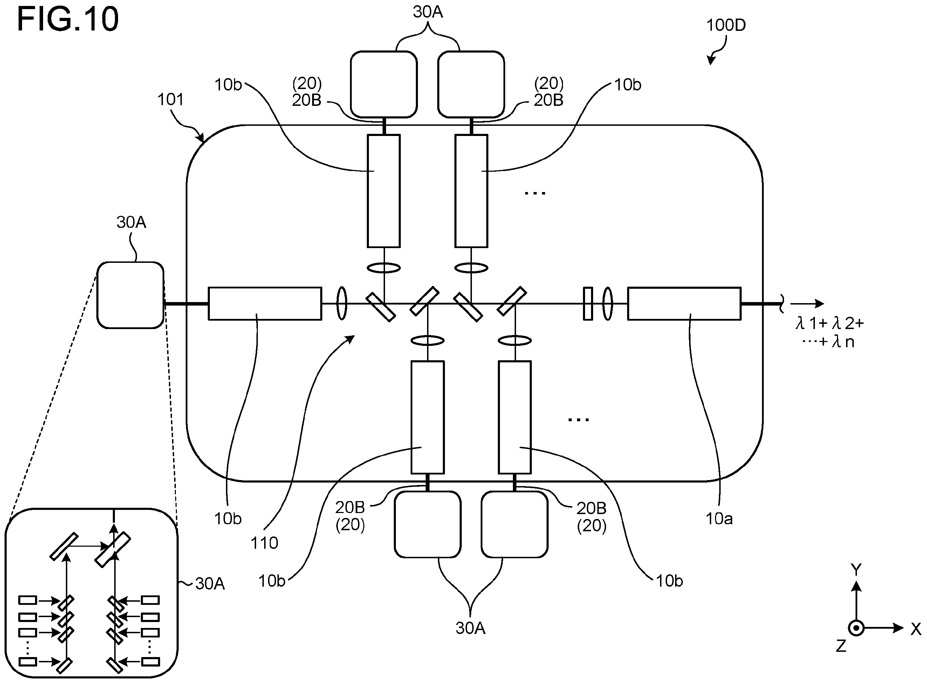

FIG. 10 is a planar view of a wavelength combining module 100D according to a fourth modification example representing a modification example of the second embodiment.

The wavelength combining module 100D illustrated in FIG. 10 includes the wavelength combining unit 110 having an identical configuration to the configuration in the wavelength combining module 100C according to the third modification example. Moreover, in the wavelength combining module 100D too, all of the optical fibers 20B are polarization maintaining optical fibers, and linear polarized lights having the same orientation of the polarization plane are input from all optical fibers 20B. The orientation of the polarization plane is set in such a way that the light input to the first face 112a and the light input to the second face 112b of each filter 112 serve as the S waves with respect to the first face 112a and the second face 112b. As a result, in the fourth modification example too, it becomes possible to achieve identical effects to the third modification embodiment. Meanwhile, instead of including a combination of the optical fibers 20B, which represent polarization maintaining optical fibers, and the filters 112, which reflect the light coming from the optical fibers 20B; the wavelength combining module 100D can include a combination of the optical fibers 20B illustrated in FIG. 5, which are not polarization maintaining optical fibers, and the filters 112 having the incidence angle equal to or smaller than 20° for the light reflected from the optical fibers 20B.

However, in the fourth modification example, in a light emitting device 30A that outputs light to the optical fibers 20B, a combined light is output that is formed as a result of combining lights having a plurality of wavelengths. The configuration of the light emitting device 30A is explained below in a third embodiment. According to the fourth modification example, for example, in comparison regarding a configuration for combining the same number of lights having different wavelengths, since a plurality of lights having different wavelengths can be combined in the light emitting device 30A, the number of optical fibers 20B connected to the wavelength combining module 100D can be reduced as compared to the third modification example. In turn, the wavelength combining module 100D can be made more compact in the X direction illustrated in FIG. 10.

### [Third embodiment]

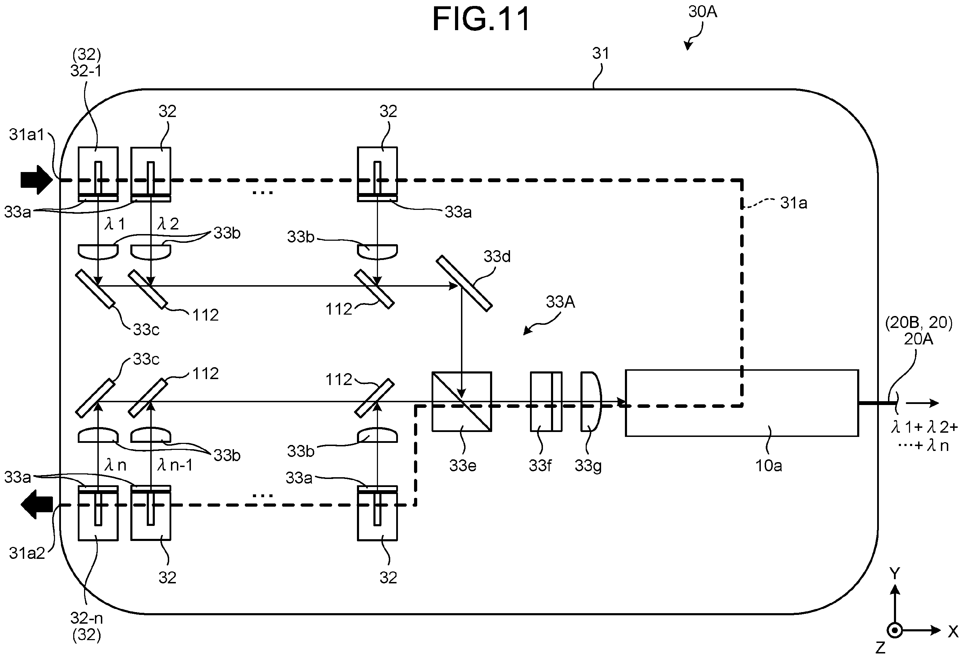

FIG. 11 is a planar view of the light emitting device 30A according to the third embodiment. As illustrated in FIG. 11, the light emitting device 30A includes a housing 31, the optical fiber 20A fixed to the housing 31, a plurality of light emitting elements 32, and a light combining unit 33A that combines the lights emitted from the light emitting elements 32. The optical fiber 20A is an output-type optical fiber and is fixed to the housing 31 via the supporting part 10a that supports the peeled end portion 20a (see FIGS. 1 to 4; not illustrated in FIG. 11).

The supporting part 10a that supports the optical fiber 20A has an identical configuration to the configuration of the supporting member 10A according to the first embodiment. Herein, some part of the supporting part 10a (for example, the base 11) can be configured in the housing 31 as a part of the housing 31. Alternatively, the supporting member 10A according to the first embodiment can be attached to the housing 31. In the light emitting device 30A, the optical fiber 20A (the output-type optical fiber) also represents the optical fiber 20B (the input-type optical fiber) of any one of the wavelength combining modules 100A to 100D.

The housing 31 has, for example, a case (not illustrated) and a lid (not illustrated), and is sealed. The housing 31 is made from a material such as copper or aluminum having high heat conductivity.

The light emitting elements 32 output lights having different wavelengths. The light emitting elements 32 are, for example, semiconductor laser modules.

The lights output from the light emitting elements 32 are combined by the light combining unit 33A. The light combining unit 33A includes optical components such as collimation lenses 33a and 33b, the filters 112, a mirror 33d, a combiner 33e, and collecting lenses 33f and 33g. The combiner 33e is meant for combining the lights having different wavelengths.

In the light emitting device 30A, two arrays in which a plurality of light emitting elements 32 is arranged at predetermined intervals (for example, regular intervals) in the X direction are placed apart from each other in the Y direction. The light emitting elements 32 output lights having different wavelengths (λ1, λ2, ..., λn). The interval among the plurality of wavelengths is, for example, in the range of 5 [nm] to 20 [nm] between the central wavelengths. Meanwhile, herein, the combined light can also include the blue laser light.

In the light combining unit 33A, the collimation lenses 33a collimate the lights in the Z direction (the fast axis direction), and the collimation lenses 33b collimate the lights in the X direction (the slow axis direction). The filters 112 are identical to the filters according to the second embodiment. The combiner 33e combines the lights coming from the two arrays and outputs the combined light toward the collecting lens 33f. The collecting lens 33f collects the light in the Z direction (the fast axis direction), and the collecting lens 33g collects the light in Y direction (the slow axis direction). The light combining unit 33A can also be called a wavelength combining unit.

Moreover, in the housing 31, a cooling passage 31a is formed for the purpose of cooling the light emitting elements 32, the supporting part 10a, the collecting lenses 33f and 33g, and the combiner 33e. In the cooling passage 31a, for example, a cooling medium such as a coolant is passed. The cooling passage 31a is formed, for example, nearby (below) the installation face of the components of the housing 31; and the inner face of the cooling passage 31a is thermally connected to the components and the regions to be cooled, that is, thermally connected to the light emitting elements 32, the supporting part 10a, the collecting lenses 33f and 33g, and the combiner 33e. Moreover, in the line of sight along the Z direction, the cooling passage 31a is formed to overlap with the maximum-temperature positions of the target components and regions for cooling.

Furthermore, the cooling passage 31a is formed in such a way that the order of cooling of the light emitting elements 32 by the cooling medium is in descending order of the wavelengths, that is, in such a way that the light emitting elements 32 that output the light having longer wavelengths have the cooling positions more on the upstream side than the light emitting elements 32 that output the lights having shorter wavelengths. As a result, from among the light emitting elements 32, the light emitting elements 32 that output the lights having longer wavelengths are cooled at an early stage by the cooling medium having a lower temperature, and the light emitting elements 32 that output the lights having shorter wavelengths are cooled at a later stage by the coolant having a higher temperature. Thus, the light output from a light emitting element 32-1, which is positioned closest to an entry 31a1 for the cooling medium in the cooling passage 31a, has the wavelength λ1 as the longest wavelength; and the light output from a light emitting element 32-n, which is positioned closest to an exit 31a2 for the cooling medium in the cooling passage 31a, has the wavelength λn as the shortest wavelength. Herein, regarding the wavelengths λ1, ..., λn; the relationship λ1>λ2>...>λn holds true.

As explained above, in the light emitting device 30A according to the third embodiment, the supporting part 10a of the peeled end portion 20a of the optical fiber 20A (the output-type optical fiber) has the same configuration as the supporting member 10A according to the first embodiment.

Hence, according to the third embodiment, for example, it becomes possible to achieve identical effects to the first embodiment.

Moreover, according to the third embodiment, for example, using the cooling medium passing through the cooling passage 31a, a plurality of light emitting elements 32 as well as the supporting part 10a can be cooled. Hence, for example, as compared to a configuration in which a cooling passage for cooling a plurality of light emitting elements 32 is separately provided from a cooling passage for cooling the supporting part 10a, the configuration of the light emitting device 30A can be more simplified.

Moreover, according to the third embodiment, for example, using the cooling medium passing through the cooling passage 31a, the light emitting elements 32 are cooled at an early stage in proportion to the wavelengths of the lights output therefrom. The temperature of any light emitting element 32 rises easily in proportion to the wavelength. Hence, with the configuration explained above, a plurality of light emitting elements 32 can be efficiently cooled using the cooling medium. Moreover, it also enables holding down the variability in the wavelengths.

### [Fifth modification example]

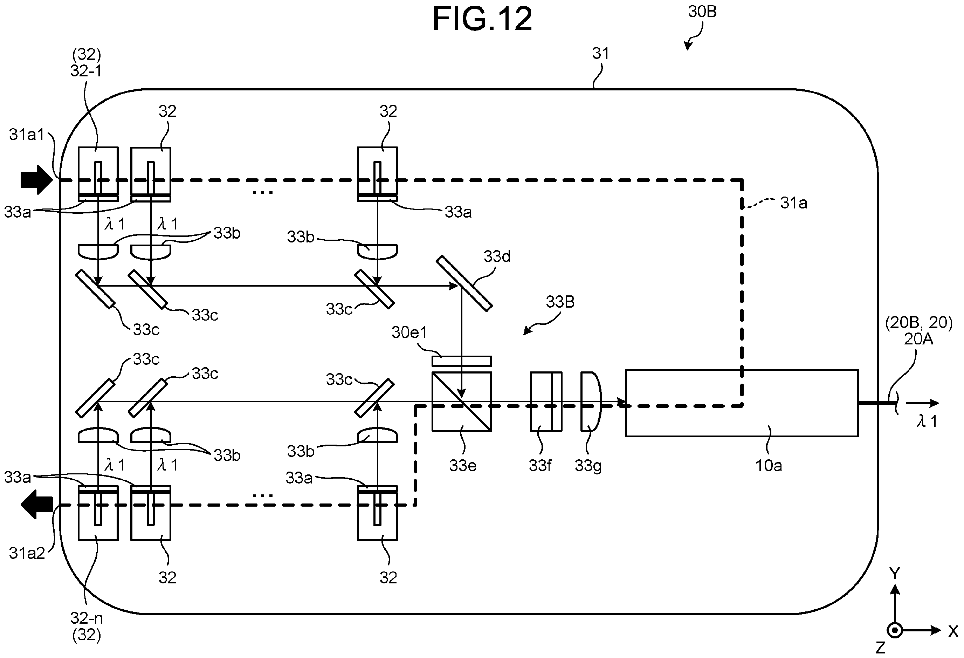

FIG. 12 is a planar view of a light emitting device according to a fifth modification example representing a modification example of the third embodiment. A light emitting device 30B combines the lights having the same wavelength λ1 (the single wavelength λ1) and outputs the combined light. The light emitting device 30B includes the housing 31, the optical fiber 20A fixed to the housing 31, the plurality of light emitting elements 32, and a light combining unit 33B that combines the lights emitted from the light emitting elements 32. In an identical manner to the third embodiment, the optical fiber 20A is an output-type optical fiber and is fixed to the housing 31 via the supporting part 10a that supports the peeled end portion 20a (see FIGS. 1 to 4; not illustrated in FIG. 11).

In the housing 31, regarding each array in which a plurality of light emitting elements 32 is arranged at predetermined intervals (for example, regular intervals) in the X direction, a stepped surface (not illustrated) is provided in such a way that, as the distance in the opposite direction of the X direction increases, the positions of the light emitting elements 32 shift in the Z direction. Each light emitting element 32 is placed on the stepped surface.

Each light emitting element 32 outputs the light having the same wavelength λ1. The light emitting elements 32 are, for example, semiconductor laser modules.

The lights output from the light emitting elements 32 are combined by the light combining unit 33B. The light combining unit 33B includes optical components such as the collimation lenses 33a and 33b, mirrors 33c, the mirror 33d, the combiner 33e, and the collecting lenses 33f and 33g.

The mirrors 33c are placed on the stepped surface of the housing 31, in an identical manner to the light emitting elements 32. Each mirror 33c reflects the light coming from the corresponding optically-coupled light emitting element 32 toward the mirror 33d or the combiner 33e. The position of the stepped surface in the Z direction and the size of the mirrors 33c are set in such a way that there is no interference among the lights coming from the mirrors 33c.

The combiner 33e includes a half-wavelength plate 33e1 that rotates the polarization plane of the light coming from one of the two arrays. The combiner 33e can also be called a polarized beam combiner.

In the fifth modification example too, using the cooling medium passing through the cooling passage 31a, a plurality of light emitting elements 32 as well as the supporting part 10a can be cooled.

### [Sixth modification example]

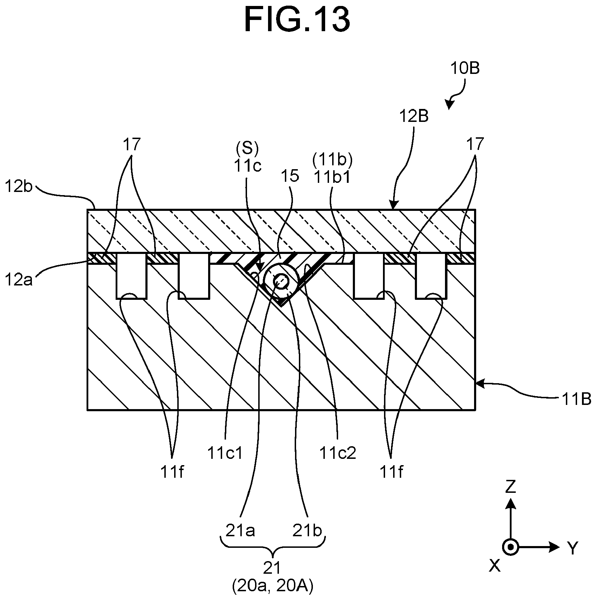

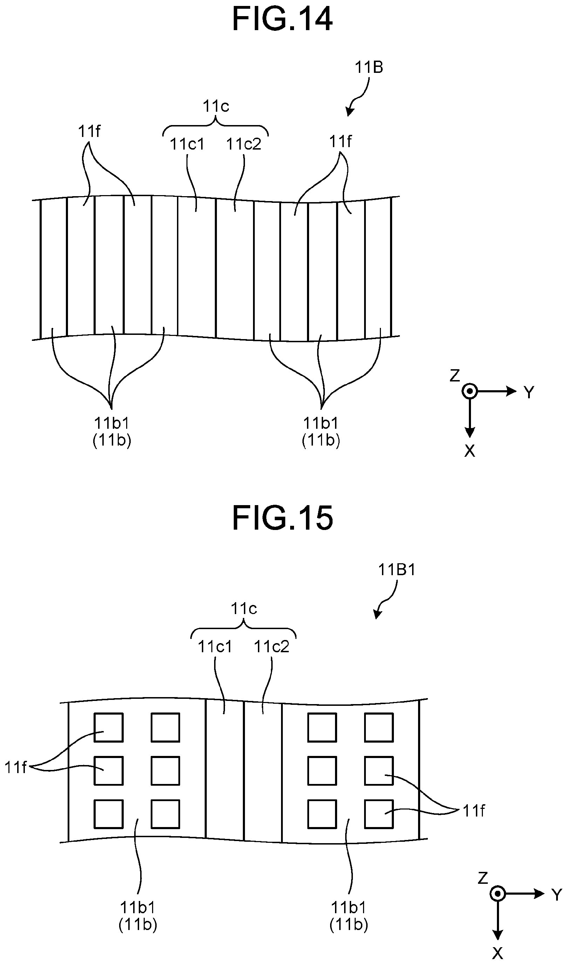

FIG. 13 is a cross-sectional view, at an equivalent position to the position illustrated in FIG. 2, of a supporting member 10B according to a sixth modification example representing a modification example of the first embodiment. FIG. 14 is a planar view of a base 11B. In the sixth modification example, the base 11B and a cover 12 have a large difference in the linear coefficients of expansion. The base 11B and a cover 12B are bonded using an adhesive agent 17. In such a configuration, if the adhesion region (the adhesion area) is too wide (large), then the difference in the linear coefficients of expansion of the adhesive agent 17 and the cover 12B leads to an increase in the stress exerted on the cover 12B. As a result, there is a risk of breakage of the cover 12B, or breakage or peeling off of the adhesive agent 17 that bonds the base 11B and the cover 12B. In that regard, in the sixth modification example, recessed portions 11f that are recessed in the opposite direction of the Z direction and that extend in the X direction are formed on the face 11b1 (11b), and accordingly the amount of the adhesive agent 17 is reduced. As a result, it becomes possible to hold down the breakage of the cover 12B. The recessed portions 11f represent what are called recessed grooves. The adhesive agent 17 can be made from a synthetic resin material in an identical manner to the processed member 15. However, the adhesive agent 17 need not have the same material as the processed member 15. Of the face 11b1, the region between the recessed portions 11f close to the optical fiber 20A and the recessed groove 11c can have a different type of the adhesive agent 17 or a different composition of the adhesive agent 17 applied therein as compared to the region between the recessed portions 11f separated from the optical fiber 20A and the recessed portions 11f close to the optical fiber 20A. That is, the type or the composition of the adhesive agent 17 can be different depending on the position on the face 11b1.

### [Seventh modification example]

FIG. 15 is a planar view of a base 11B1 according to a seventh modification example representing a modification example of the first embodiment. Meanwhile, the base 11B1 can be replaced by the base 11B according to the sixth modification example. As illustrated in FIG. 15, in the seventh modification example, a plurality of recessed portions 11f is provided with a different form than in the sixth modification example. The recessed portions are recessed from the face 11b1 (11b) in the opposite direction of the Z direction, and represent what are called cavities. The cross-sectional surface of the recessed portions 11f in the Z direction is quadrangular in shape. In an identical manner to the recessed portions 11f according to the sixth modification example, the recessed portions 11f do not penetrate the base 11B1 in the Z direction. Moreover, the recessed portions 11f are arranged as a matrix in the X direction and the Y direction. However, they can be lined up in other directions, or may not be lined up. According to the seventh modification example too, it becomes possible to achieve identical effects to the sixth modification example.

### [Eighth modification example]

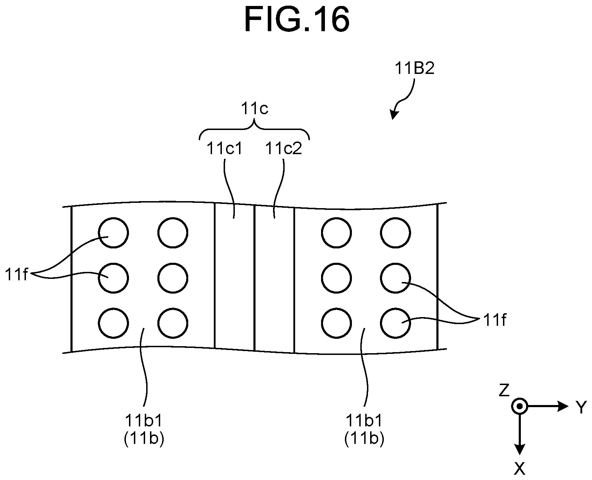

FIG. 16 is a planar view of a base 11B2 according to an eighth modification example representing a modification example of the first embodiment. Meanwhile, the base 11B2 can be replaced by the base 11B according to the sixth modification example. The base 11B2 according to the eighth modification example is same as the base 11B1 according to the seventh modification example, except that the cross-sectional surface is circular in shape. According to the eighth modification example too, it becomes possible to achieve identical effects to the sixth modification example.

### [Fourth embodiment]

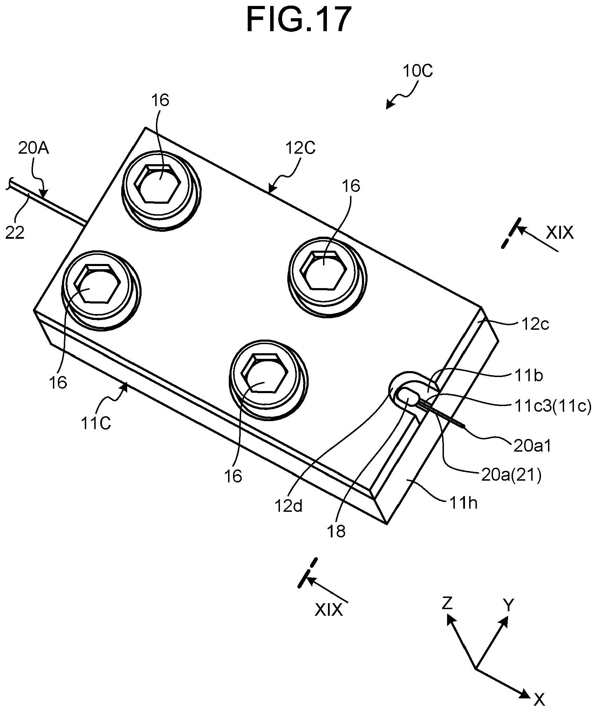

FIG. 17 is a perspective view of a supporting member 10C according to a fourth embodiment. As illustrated in FIG. 17, in the fourth embodiment, at an end portion 12c in the X direction of a cover 12C, an opening 12d is formed as a notch that is recessed in the opposite direction of the X direction. The opening 12d penetrates through the cover 12C in the Z direction, that is, in the thickness direction of the cover 12. Because of the opening 12d; the face 11b of a base 11C, the recessed groove 11c formed on the face 11b, and the peeled end portion housed in the recessed groove 11c get partially exposed in the Z direction and the X direction.

As illustrated in FIG. 17, in the region exposed due to the opening 12d, the face 11b and the recessed groove 11c are fixed to the peeled end portion 20a by a fixating member 18. The fixating member 18 is, for example, an adhesive agent such as an inorganic adhesive agent. The fixating member 18 is applied in the fluid state and is then hardened. Alternatively, for example, the fixating member 18 can be an electromagnetic-radiation-curable adhesive agent that hardens when irradiated with ultraviolet light or visible light, or can be a heat-curable adhesive agent that hardens due to heating. In that case, the fixating member 18 in the fluid state can be hardened by applying electromagnetic radiation or heat to it. When the fixating member 18 is an electromagnetic-radiation-curable adhesive agent, it can be irradiated with electromagnetic radiation for hardening purpose via the opening 12d.

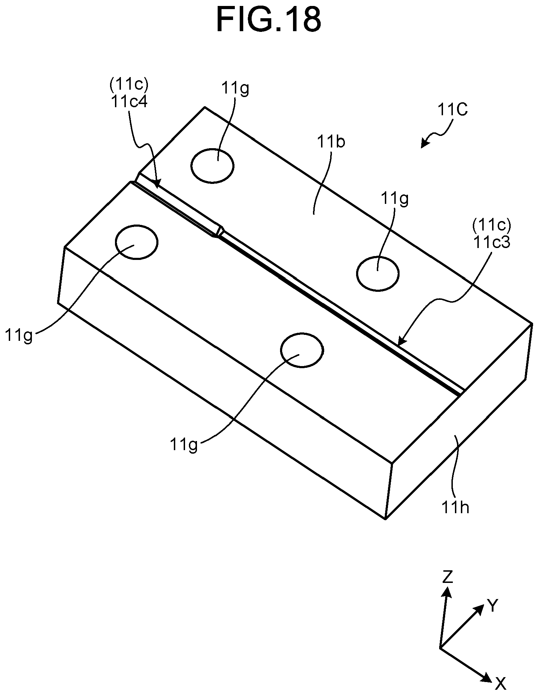

FIG. 18 is a perspective view of the base 11C. As illustrated in FIG. 18, the recessed groove 11c formed on the face 11b of the base 11C extends in the X direction; and includes a section 11c3, in which the peeled end portion 20a of the optical fiber 20A is housed, and a section 11c4, in which the region of the optical fiber 20A covered by the jacket 22 is housed. By referring to FIGS. 18 and 17, it becomes clear that, in the fourth embodiment, because of the opening 12d, the section 11c3 of the recessed groove 11c that is on the side of an end portion 11h becomes partially exposed.

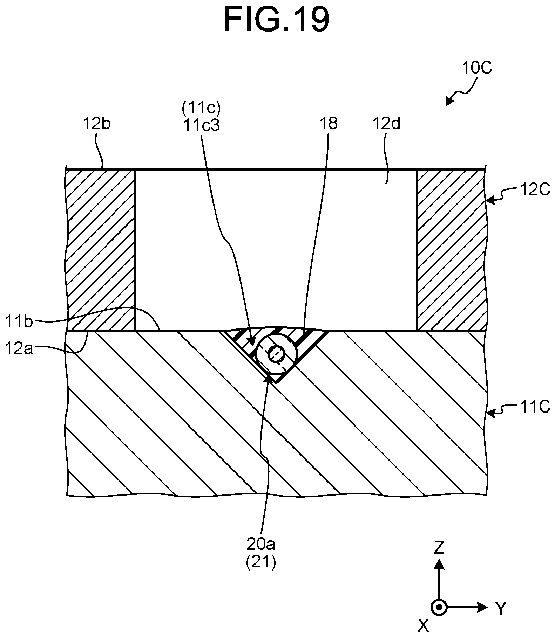

FIG. 19 is an XIX-XIX cross-sectional view of FIG. 17. As illustrated in FIG. 19, the fixating member 18 is housed along with the peeled end portion 20a in the section 11c3 of the V-shaped recessed groove 11c, and encloses the peeled end portion 20a. In that state, the fixating member 18 bonds and fixates the base 11C and the peeled end portion 20a. The section 11c3 represents an example of a second recessed groove.

Meanwhile, that region of the cover 12C which, with respect to the opening 12d, is on the opposite side of the end portion 12c in the X direction, and the base 11C have an identical configuration to the configuration illustrated in FIG. 2 according to the first embodiment.

As explained above, in the fourth embodiment, the fixating member 18 fixates the peeled end portion 20a, which is a part of the optical fiber 20A, and the base 11C (the first member). With such a configuration, it becomes possible to more reliably prevent relative mispositioning between the optical fiber 20A and the base 11C, and in turn between the optical fiber 20A and the supporting member 10C.

Moreover, in the fourth embodiment, in the cover 12C (the second member), the opening 12d is formed through which the fixating member 18 is exposed. With such a configuration, the opening 12d functions as the clearance for the fixating member 18. In a configuration not having the opening 12d, if an excessive amount of the fixating member 18 is applied, then the fixating member 18 enters the space in between the face 11b of the base 11C and the face 12a of the cover 12C, and as a result the base 11C and the cover 12C may not adhere tightly to each other. Hence, if the opening 12d is not formed, the amount of application of the fixating member 18 needs to managed in a more stringent manner. In that regard, according to the fourth embodiment, since the opening 12d functions as the clearance for the fixating member 18, the amount of application of the fixating member 18 need not be managed as stringently as in the case of not having the opening 12d. In turn, the assembly of the supporting member 10C can be done more easily and more promptly.

Moreover, as illustrated in FIG. 17, in the fourth embodiment, the fixating member 18 is positioned distantly from the following in the opposite direction of the X direction: the leading end 20a1 (a first end portion) of the peeled end portion 20a; the end portion 11h in the X direction of the base 11C; and the end portion 12c in the X direction of the cover 12C. With such a configuration, the laser light that travels toward the leading end 20a1 in the opposite direction of the X direction but that is not coupled with the leading end 20a1 does not easily reach the fixating member 18. Moreover, even if the laser light that is not coupled with the leading end 20a1 reaches the fixating member 18, the energy density of the laser light can be reduced. Hence, with such a configuration, it becomes possible to hold down excessive heating or damage of the fixating member 18 attributed to irradiation with the laser light that is not coupled with the leading end 20a1. Herein, the end portions 11h and 12c represent examples of a second end portion.

Moreover, in the fourth embodiment, the section 11c3 (the second recessed groove) of the recessed groove 11c is formed in the base 11C. The section 11c3 is used for housing that region of the peeled end portion 20a which is fixed to the base 11C by the fixating member 18. With such a configuration, as compared to the case in which the section 11c3 of the recessed groove 11c is not provided on the face 11b and in which the fixating member 18 is applied to form a mound around the peeled end portion 20a, the fixating member 18 can be placed around the peeled end portion 20a in a more reliable manner. That is, as a result of forming the section 11c3 of the recessed groove 11c in which the peeled end portion 20a and the fixating member 18 are housed, the peeled end portion 20a and the base 11C can be more strongly fixed using the fixating member 18.

Meanwhile, although the supporting member 10C according to the fourth embodiment does not include the end cap 13, the configuration according to the fourth embodiment can be implemented also when the end cap 13 is included.

### [Ninth modification example]

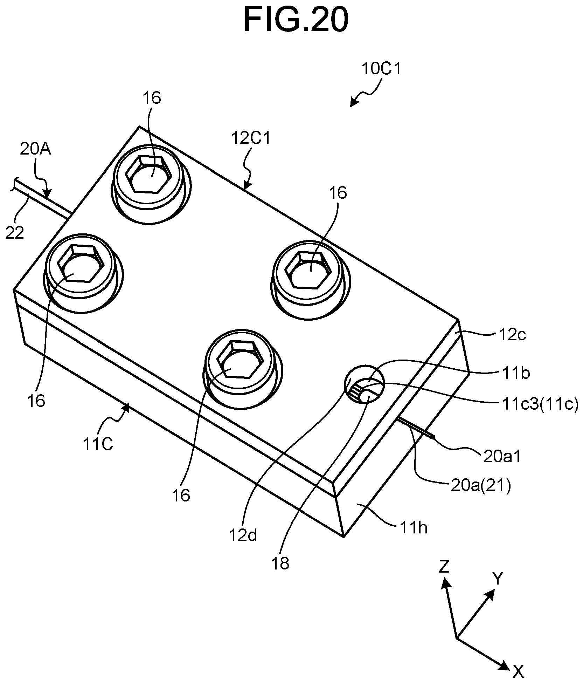

FIG. 20 is a perspective view of a supporting member 10C1 according to a ninth modification example representing a modification example of the fourth embodiment. As illustrated in FIG. 20, in the ninth modification example, the opening 12d is a through hole that is formed at a position away from the end portion 12c in the opposite direction of the X direction and that penetrates through a cover 12C1 in the Z direction. As a result, the fixating member 18 gets exposed in the Z direction. Except for that point, the supporting member 10C1 according to the ninth modification example has an identical configuration to the supporting member 10C according to the fourth embodiment.

In the ninth modification example, since the opening 12d is positioned away from the end portion 12c, the region in between the end portion 12c and the opening 12d of the cover 12C1 serves as a barrier for blocking the laser light, which is not coupled with the leading end 20a1, from reaching the fixating member 18. Hence, with such a configuration, it becomes possible to further hold down excessive heating or damage of the fixating member 18 attributed to irradiation with the laser light that is not coupled with the leading end 20a1. Herein, the end portion 12c represents an example of a third end portion.

Meanwhile, an opening 12D is not limited to be a through hole. Alternatively, for example, the opening 12d can be a notch formed at the end portion ether in the Y direction of the cover 12C1 or in the opposite direction of the Y direction of the cover 12C1.

### [10-th modification example]

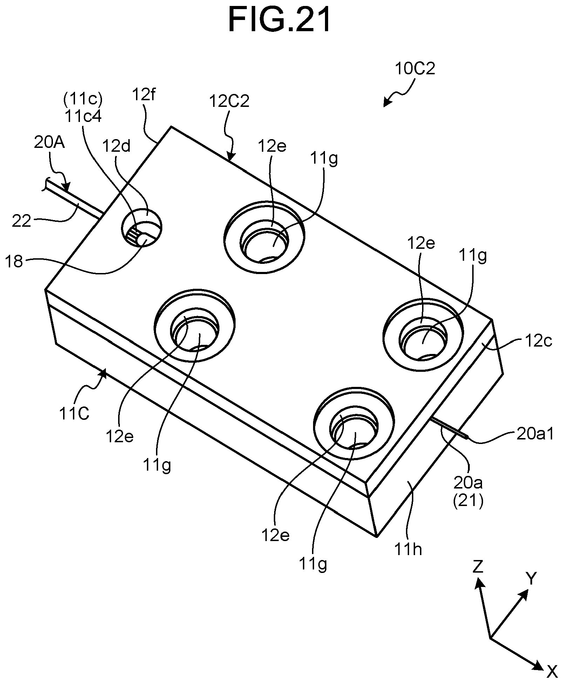

FIG. 21 is a perspective view of a supporting member 10C2 according to a 10-th modification example representing a modification example of the fourth embodiment. In FIG. 21, the fixtures 16 are not illustrated. The bolts representing the fixtures 16 are passed inside through holes 12e formed in a cover 12C2, and are coupled with female screw holes 11g formed in the base 11C.

As illustrated in FIG. 21, in the 10-th modification example too, in an identical manner to the ninth modification example, the opening 12d is a through hole that is formed at a position away from the end portion 12c in the opposite direction of the X direction and that penetrates through the cover 12C2 in the Z direction. As a result, the fixating member 18 gets exposed in the Z direction. However, in the 10-th modification example, the opening 12d is formed closer to an end portion 12f of the cover 12C2, which is in the opposite direction of the X direction, than to the end portion 12c in the X direction of the cover 12C2. Moreover, the region in between the end portion 12c and the opening 12d of the cover 12C2 and the base 11C have an identical configuration to the configuration illustrated in FIG. 2 according to the first embodiment. That is, with respect to the processed member 15, the fixating member 18 is positioned on the opposite side of the leading end 20a1 of the peeled end portion 20a, and the relative positional relationship (arrangement) of the fixating member 18 and the processed member 15 in the X direction is contrary to the fourth embodiment and the ninth modification example. Except for these points, the supporting member 10C2 according to the 10-th modification example has an identical configuration to the supporting member 10C according to the fourth embodiment and the supporting member 10C1 according to the ninth modification example.

In the 10-th modification example too, since the opening 12d is positioned away from the end portion 12c, the region in between the end portion 12c and the opening 12d of the cover 12C2 serves as a barrier for blocking the laser light, which is not coupled with the leading end 20a1, from falling onto the fixating member 18. Herein, the distance between the opening 12d and the end portion 12c is greater than the distance in the ninth modification example. As a result, according to the 10-th modification example, it becomes possible to further hold down excessive heating or damage of the fixating member 18 attributed to irradiation with the laser light that is not coupled with the leading end 20a1.

Moreover, in the 10-th modification example, in the V-shaped recessed groove 11c, the fixating member 18 is housed along with that region of the optical fiber 20A which is covered by the jacket 22 in the section 11c4. Moreover, the fixating member 18 encloses the region covered by the jacket 22. With such a configuration, the fixating member 18 bonds and fixates the base 11C to the region covered by the jacket 22. In this case, the section 11c4 represents an example of a second recessed groove.

In the 10-th modification example too, the opening 12d is not limited to be a through hole. Alternatively, for example, the opening 12d can be a notch formed at the end portion either in the Y direction of the cover 12C2 or in the opposite direction of the Y direction of the cover 12C2, or can be a notch formed at the end portion 12f in the opposite direction of the X direction.

### [Fifth embodiment]

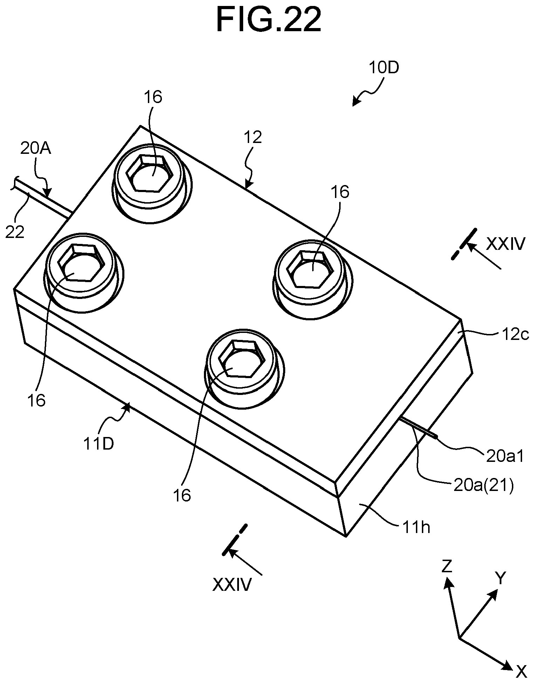

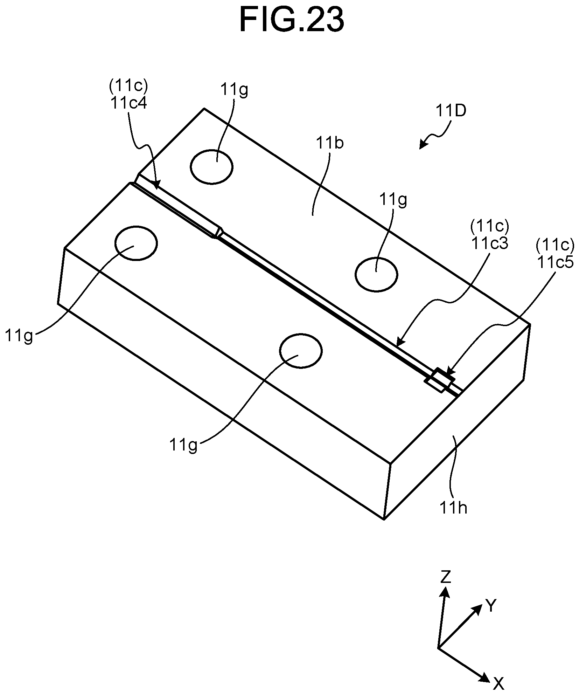

FIG. 22 is a perspective view of a supporting member 10D according to a fifth embodiment. As illustrated in FIG. 22, in the fifth embodiment, the cover 12 does not have the opening 12d formed therein. FIG. 23 is a perspective view of a base 11D. As illustrated in FIG. 23, in the base 11D, in the section 11c3 of the recessed groove 11c, a recessed portion 11c5 is formed.

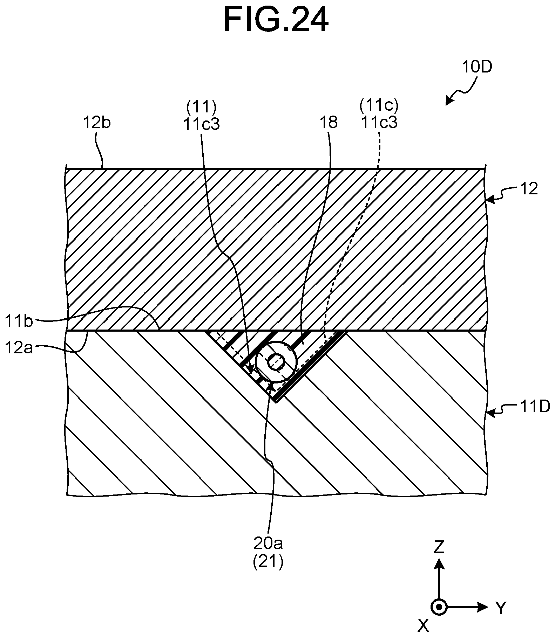

FIG. 24 is an XXIV-XXIV cross-sectional view of FIG. 22, and is a cross-sectional view of the supporting member 10D at the position at which the recessed portion 11c5 is formed. As illustrated in FIG. 24, the recessed portion 11c5 has, for example, a V-shaped cross-sectional surface intersecting with the X direction, and constitutes a recessed groove running deeper in the opposite direction of the Z direction as compared to the section 11c3. The fixating member 18 is housed along with the peeled end portion 20a in the recessed portion 11c5, and encloses the peeled end portion 20a in the recessed portion 11c5. Except for those points, the supporting member 10D according to the fifth embodiment has an identical configuration to the supporting member 10C according to the fourth embodiment.

In the fifth embodiment, since the recessed portion 11c5 is formed in the base 11D, as compared to the case in which the recessed portion 11c5 is not formed, there is an increase in the volumetric capacity for the fixating member 18. Thus, using a greater quantity of the fixating member 18, the peeled end portion 20a and the recessed portion 11c5 can be fixed more strongly. Moreover, since it becomes possible to secure a greater margin for the volumetric capacity of the recessed portion 11c5 with respect to the required volumetric capacity of the fixating member 18, the recessed portion 11c5 serves as the clearance for the fixating member 18. Hence, the amount of application of the fixating member 18 need not be managed as stringently as in the case of not having the recessed portion 11c5. In turn, the assembly of the supporting member 10D can be done more easily and more promptly.

Moreover, as is clear from FIG. 23, as a result of having the recessed portion 11c5, as compared to the case of not having the recessed portion 11c5, a worker or a robot camera finds it easier to recognize the position of application of the fixating member 18, which is in the fluid state, on the base 11D. In turn, the positional accuracy of the fixating member 18 can be easily enhanced. Moreover, because of the lateral faces (end faces) of the recessed portion 11c5 in the X direction and the opposite direction of the X direction, the applied fixating member 18 in the fluid state can be prevented from flowing in the X direction and the opposite direction of the X direction. Thus, the recessed portion 11c5 can also serve as a positioning member for the fixating member 18 or as a mispositioning prevention member.

### [Sixth embodiment]

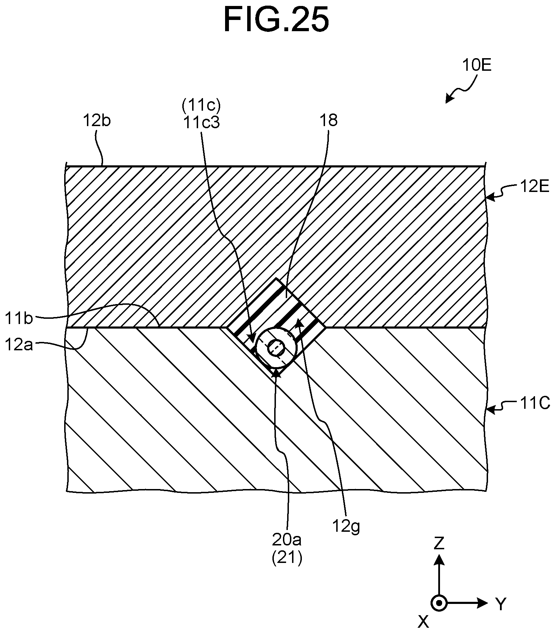

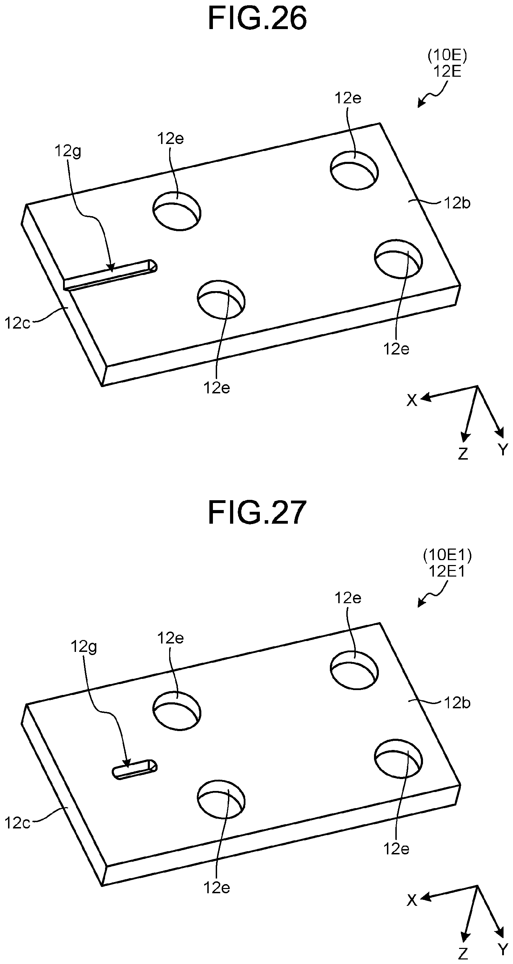

FIG. 25 is a cross-sectional view, at an equivalent position to the position illustrated in FIG. 19, of a supporting member 10E according to a sixth embodiment. FIG. 26 is a perspective view of the line of sight along which the face 12a of a cover 12E is visible. As is clear from FIGS. 25 and 26, in the sixth embodiment, a recessed portion 12g is formed in the cover 12E. The recessed portion 12g is formed at a position that overlaps with the section 11c3 of the recessed groove 11c in the Z direction. The fixating member 18 is housed in the section 11c and the recessed portion 12g, and encloses the peeled end portion 20a within the space formed due to the section 11c3 and the recessed portion 12g. Except for that point, the supporting member 10E according to the sixth embodiment has an identical configuration to the supporting member 10D according to the fifth embodiment.

The recessed portion 12g is formed as a recessed groove that extends in the X direction and that becomes continuous with the end portion 12c. As illustrated in FIG. 25, the recessed portion 12g has, for example, a V-shaped cross-sectional surface intersecting with the X direction.

In the sixth embodiment, as a result of forming the recessed portion 12g in the cover 12E, as compared to the case in which the recessed portion 12g is not formed, there is an increase in the volumetric capacity for the fixating member 18. Hence, according to the sixth embodiment too, it becomes possible to achieve identical effects to the fifth embodiment.

### [11-th modification example]

FIG. 27 is a perspective view of a cover 12E1 of a supporting member 10E1 according to an 11-modification example representing a modification example of the sixth embodiment. As illustrated in FIG. 27, in the 11-th modification example, the recessed portion 12g is shorter than in the sixth embodiment, and does not reach the end portion 12c. Except for that point, the supporting member 10E1 according to the 11-th modification example has an identical configuration to the supporting member 10E according to the sixth embodiment.

With the configuration according to the sixth embodiment too, it becomes possible to achieve identical effects to the sixth embodiment. Moreover, because of the lateral faces (end faces) of the recessed portion 12g in the X direction and the opposite direction of the X direction, the applied fixating member 18 in the fluid state can be prevented from flowing in the X direction and the opposite direction of the X direction. Thus, the recessed portion 12g can also serve as a positioning member for the fixating member 18 or as a mispositioning prevention member.

While certain embodiments and modification examples have been described, these embodiments and modification examples have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions. Moreover, regarding the constituent elements, the specifications about the configurations and the shapes (structure, type, direction, shape, size, length, width, thickness, height, number, arrangement, position, material, etc.) can be suitably modified.

For example, regarding a supporting part for an optical fiber in a wavelength combining module or a light emitting device, the structure of the supporting part need not be identical to the supporting member according to the first embodiment. Alternatively, as an example, it is possible to adapt the structure disclosed in WO2015/037725A1. As another example, the peeled end portion and the glass capillary can be integrated in at least some section.

Moreover, for example, the light emitting device can have volume bragg grating (VBG); and fiber bragg grating (FBG) can be disposed midway of the optical fiber between the light emitting device and the wavelength combining module. With that, a wavelength locking function can be provided.

Furthermore, the light emitting device can be configured in such a way that at least one of the light emitting elements outputs visible light and the remaining light emitting elements output lights having the near-infrared wavelength. In that case, the visible light can be used as a guiding light for deciding the irradiation position of the light that is output to the outside from the light emitting device via the optical fiber.

Moreover, the specifications about the cross-sectional shape of a recessed portion or a recessed groove are not limited to the embodiments and the modification examples described above.

### Industrial Applicability

The present invention can be applied in a supporting member, a wavelength combining module, and a light emitting device.

### Reference Signs List

10A, 10A1, 10B, 10C, 10C1, 10C2, 10D, 10E, 10E1 supporting member
10a supporting part
10b, 10b1, 10b2 supporting part
11, 11B, 11B1, 11B2, 11C, 11D base (first member)
11a face
11b face
11b1, 11b2, 11b3 face
11c recessed groove (first recessed groove)
11c1, 11c2 face
11c3 section (second recessed groove)
11c4 section (second recessed groove)
11c5 recessed portion
11d reflection member
11d1, 11d2 reflecting surfaces
11d3 leading end
11e end face
11f recessed portion
11g female screw hole
11h end portion (second end portion)
12, 12B, 12C, 12C1, 12C2, 12E, 12E1 cover (second member)
12a face
12b face
12c end portion (second end portion, third end portion)
12d opening
12d through hole
12f end portion
12g recessed portion
13 end cap
13a columnar portion
13a1 end face
13b protruding portion
14 holder
14a end face
15 processed member
16 fixture
17 adhesive agent
18 fixating member
20, 20A, 20B, 20B1, 20B2, 20B3 optical fiber
20a peeled end portion
20a1 leading end (first end portion)
20a2 section
21 core wire
21a core
21b cladding
22 jacket
30A light emitting device
30B light emitting device
31 housing
31a cooling passage
31a1 entry
31a2 exit
32, 32-1, 32-n light emitting element
33A, 33B light combining unit
33a collimation lens
33b collimation lens
33c mirror
33d mirror
33e combiner
33e1 half-wavelength plate
33f collecting lens
33g collecting lens
100A to 100D wavelength combining module
101 housing
110 wavelength combining unit (light combining unit)
111 collimation lens
112, 112-1, 112-2 filter
112a first face
112b second face
113 collecting lens
114 sensor
115 reflected-light cutoff filter
Ax optical axis
f1, f2 frequency
D1 direction (first input direction)
D2 direction (second input direction)
Po, Pe light path
S space (housing portion)
X direction (first direction)
Y direction
Z direction
θ incidence angle
λ1 to λn, λmin, λmax wavelength

## Claims

1. A supporting member for supporting a peeled end portion formed at an end portion in longitudinal direction representing first direction of an optical fiber, the optical fiber including: a core wire including a core and a cladding; and a jacket configured to enclose the core wire, the jacket being removed at the peeled end portion to expose the core wire, the supporting member comprising:
a first member;
a second member fixed to the first member;
a housing portion provided between the first member and the second member, the housing portion extending along the peeled end portion and being configured to house the peeled end portion; and
a processed member housed in the housing portion and provided around the peeled end portion, the processed member being configured to cause transmission or scattering of light leaking from the peeled end portion.

2. The supporting member according to claim 1, wherein
the first member includes a first recessed groove configured to house the peeled end portion, and
the second member is configured to cover the first recessed groove and the peeled end portion.

3. The supporting member according to claim 2, wherein the first recessed groove is a V-shaped groove.

4. The supporting member according to any one of claims 1 to 3, wherein the first member and the second member support the peeled end portion in a state in which a section having a predetermined length from a first end portion in the first direction of the peeled end portion is exposed from the housing portion.

5. The supporting member according to any one of claims 1 to 4, further comprising a fixating member configured to fixate at least either the first member or the second member to the optical fiber.

6. The supporting member according to claim 5, wherein the fixating member is positioned away from a second end portion present in the first direction of at least either the first member or the second member in opposite direction of the first direction.

7. The supporting member according to claim 5 or 6, wherein at least either the first member or the second member includes a second recessed groove configured to house a region of the optical fiber fixed using the fixating member.

8. The supporting member according to any one of claims 5 to 7, wherein at least either the first member or the second member includes a recessed portion configured to house the fixating member.

9. The supporting member according to claim 8, wherein the recessed portion is positioned away from a second end portion present in the first direction of at least either the first member or the second member in opposite direction of the first direction.

10. The supporting member according to any one of claims 5 to 9, wherein
the fixating member is configured to fixate one of the first member and the second member to the optical fiber, and
another one of the first member and the second member includes an opening from which the fixating member is exposed.

11. The supporting member according to claim 10, wherein the opening is positioned away from a third end portion present in the first direction of the other member in opposite direction of the first direction.

12. The supporting member according to any one of claims 5 to 11, wherein the fixating member is positioned, with respect to the processed member, on opposite side of a first end portion present in the first direction of the peeled end portion.

13. The supporting member according to any one of claims 5 to 12, wherein the fixating member is an inorganic adhesive agent.

14. The supporting member according to any one of claims 1 to 13, further comprising a cushioning member disposed facing a first end portion present in first direction of the peeled end portion, the cushioning member including an end face positioned on opposite side of the first end portion, the end face being wider than the first end portion, and the cushioning member being configured to propagate incident light from the end face to the first end portion.

15. The supporting member according to claim 14, further comprising a reflecting surface facing the cushioning member and configured to reflect light coming from the cushioning member in a direction away from the cushioning member.

16. The supporting member according to any one of claims 1 to 15, wherein at least either the first member or the second member is made of copper or aluminum.

17. A wavelength combining module comprising:
a plurality of optical fibers each including
a core wire including a core and a cladding,
a jacket configured to enclose the core wire, and
a peeled end portion where the jacket is removed to expose the core wire at an end portion in longitudinal direction, the plurality of optical fibers including a plurality of input-type optical fibers each of which inputs light having a different wavelength, and an output-type optical fiber which outputs light;
a plurality of supporting parts configured to support the peeled end portion of the plurality of optical fibers; and
a light combining unit configured to
combine lights having different wavelengths and coming from the input-type optical fibers, and
send combined light to the output-type optical fiber, wherein
at least one of the plurality of supporting parts includes
a first member,
a second member fixed to the first member,
a housing portion provided between the first member and the second member, the housing portion extending along the peeled end portion and being configured to house the peeled end portion, and
a processed member housed in the housing portion and provided around the peeled end portion, the processed member being configured to cause transmission or scattering of light leaking from the peeled end portion.

18. The wavelength combining module according to claim 17, wherein
the input-type optical fibers includes
a first input-type optical fiber configured to input, in a first input direction, light having a first wavelength, and
a second input-type optical fiber configured to input, in a second input direction, light having a second wavelength which is different than the first wavelength, and
the light combining unit includes
a filter configured to
allow passage of light having the first wavelength, and
reflect light having the second wavelength,
a first face on which light having the first wavelength falls in the first input direction, and
a second face which is substantially parallel to the first face, from which light having the first wavelength goes out, on which light having the second wavelength falls in the second input direction, and from which light having the second wavelength goes out substantially parallel to outgoing direction of light having the first wavelength, and
the filter having incidence angle of light having the second wavelength with respect to the second face to be greater than 0° and equal to smaller than 20°.

19. The wavelength combining module according to claim 17 or 18, wherein light input from at least one of the input-type optical fibers includes a plurality of lights having different orientations of polarization plane.

20. The wavelength combining module according to claim 18 or 19, wherein the plurality of input-type optical fibers are polarization maintaining optical fibers.

21. The wavelength combining module according to claim 20, wherein light input from at least one of the plurality of input-type optical fibers includes a plurality of lights having different wavelengths.

22. A light emitting device comprising:
a plurality of light emitting elements;
a light combining unit configured to combine light coming from the plurality of light emitting elements;
an output-type optical fiber configured to output combined light obtained by the light combining unit, and including
a core wire including a core and a cladding,
a jacket configured to enclose the core wire, and
a peeled end portion where the jacket is removed to expose the core wire; and
a supporting part configured to support the peeled end portion, the supporting part including
a first member,
a second member fixed to the first member,
a housing portion provided between the first member and the second member, the housing portion extending along the peeled end portion and being configured to house the peeled end portion, and
a processed member housed in the housing portion and provided around the peeled end portion, the processed member being configured to cause transmission or scattering of light leaking from the peeled end portion.

23. The light emitting device according to claim 22, further comprising a housing including a cooling passage configured to enable passage of a cooling medium, the housing being configured to enable cooling of the plurality of light emitting elements and the supporting part when a cooling medium is passed through the cooling passage.

24. The light emitting device according to claim 23, wherein
the plurality of light emitting elements are configured to emit lights having different wavelengths, and
order of cooling of the light emitting elements due to cooling medium passing through the cooling passage is according to descending order of wavelengths of lights emitted from the light emitting elements.
